# EUROPEAN PATENT APPLICATION

(11) **EP 4 535 427 A1**
(43) Date of publication of application: **09.04.2025**
(21) Application number: 22945031.7
(22) Date of filing: 18.11.2022
(51) Int. Cl.: H01L 27/15, H01L 33/38, H01L 33/44, H01L 25/075

(54) **LIGHT-EMITTING DEVICE, DISPLAY DEVICE COMPRISING SAME, AND METHOD FOR MANUFACTURING LIGHT-EMITTING DEVICE**

(30) Priority: 31.05.2022 KR 20220067137
(71) Applicant: Samsung Display Co., Ltd., Gyeonggi-do 17113 (KR)
(72) Inventor: KANG, Hye Lim, Yongin-si, Gyeonggi-do 17113 (KR); KIM, Si Sung, Yongin-si, Gyeonggi-do 17113 (KR); KIM, Hyung Seok, Yongin-si, Gyeonggi-do 17113 (KR); LEE, Dong Eon, Yongin-si, Gyeonggi-do 17113 (KR); LEE, Jong Jin, Yongin-si, Gyeonggi-do 17113 (KR)
(74) Representative: Marks & Clerk LLP
(86) International application number: PCT/KR2022/018289
(87) International publication number: WO 2023/234493

(57) **Abstract**

This light-emitting device comprises: a first semiconductor layer; a light-emitting layer arranged on the first semiconductor layer; a second semiconductor layer arranged on the light-emitting layer; an electrode layer arranged on the second semiconductor layer; and an insulating coat film. The insulating coat film surrounds side surfaces of the first semiconductor layer, the light-emitting layer, and the second semiconductor layer, and surrounds a portion of the electrode layer at a first end portion on which the electrode layer is arranged. The electrode layer includes a first surface adjacent to the second semiconductor layer, and a second surface facing the first surface and having a width greater than that of the first surface.

## Description

### Technical Field

The disclosure relates to a light emitting element, a display device including the same, and a method of fabricating a light emitting element.

### Background Art

Interest in information displays continues to increase. Accordingly, research and development of display devices continues to be conducted.

### Detailed Description of Invention

### Technical Problem

Embodiments provide a light emitting element, a display device including the same, and a method of fabricating a light emitting element, which can prevent a short-circuit defect.

The problems of the present invention are not limited to the problems mentioned above, and other unmentioned problems will be clearly understood by those skilled in the art from the description below.

### Technical Solution

In accordance with an aspect of the disclosure, there is provided a light emitting element that includes a first semiconductor layer, a light emitting layer disposed on the first semiconductor layer, a second semiconductor layer disposed on the light emitting layer, an electrode layer disposed on the second semiconductor layer, and an insulative film surrounding side surfaces of the first semiconductor layer, the light emitting layer, and the second semiconductor layer, the insulative film surrounding a portion of the electrode layer at a first end portion at which the electrode layer is disposed. The electrode layer includes a first surface adjacent to the second semiconductor layer, and a second surface facing the first surface, the second surface having a width greater than a width of the first surface of the electrode layer.

The width of the second surface of the electrode layer may be greater than or equal to a width of an upper surface of the second semiconductor layer, which contacts the first surface.

The width of the first surface of the electrode layer may be smaller than or equal to the width of the upper surface of the second semiconductor layer.

The electrode layer may further include a side surface extending from the first surface to the second surface. The side surface of the electrode layer may have a slope corresponding to an angle in a range of about 90 degrees to about 135 degrees with respect to the first surface.

The insulative film may have a thickness changed at the first end portion.

The insulative film may have a thickness increasing as it becomes closer to the first surface of the electrode layer from the second surface of the electrode layer.

A concave groove may be formed in the electrode layer at a boundary at which the electrode layer contacts the second semiconductor layer.

The insulative film may completely surround side surfaces of the light emitting layer and the second semiconductor layer.

The first surface of the electrode layer may directly contact the second semiconductor layer.

The insulative film may surround at least a portion of the side surface of the electrode layer, which may be located at the periphery of the first surface of the electrode layer. The insulative film may expose the second surface of the electrode layer.

The insulative film may expose a lower surface of the first semiconductor layer.

The first semiconductor layer may include a first part adjacent to the light emitting layer and a second part except the first part, and a width of the first part may be greater than a width of the second part.

The insulative film may have a thickness at a portion surrounding the second part of the first semiconductor layer, which may be greater than a thickness at a portion surrounding the first part of the first semiconductor layer.

In accordance with another aspect of the disclosure, there is provided a display device that includes a pixel including a first electrode, a second electrode, and a light emitting element including a first end portion electrically connected to the first electrode and a second end portion electrically connected to the second electrode. The light emitting element includes a first semiconductor layer, a light emitting layer, a second semiconductor layer, and an electrode layer, which are sequentially disposed in a direction from the second end portion to the first end portion, and an insulative film surrounding side surfaces of the first semiconductor layer, the light emitting layer, the second semiconductor layer, and the electrode layer. The electrode layer includes a first surface adjacent to the second semiconductor layer, and a second surface facing the first surface, the second surface having a width greater than a width of the first surface.

The insulative film may completely surround side surfaces of the light emitting layer and the second semiconductor layer.

The first surface of the electrode layer may directly contact the second semiconductor layer. The insulative film may surround at least a portion of the side surface of the electrode layer, which may be located at the periphery of the first surface of the electrode layer. The insulative film may expose the second surface of the electrode layer.

In accordance with still another aspect of the disclosure, there is provided a method of fabricating a light emitting element. The method includes sequentially forming a first semiconductor layer, a light emitting layer, and a second semiconductor layer on a substrate, sequentially forming a mask layer and an etch pattern on the second semiconductor layer, patterning, in a rod shape, a stack structure including the first semiconductor layer, the light emitting layer, and the second semiconductor layer through an etching process using the mask layer and the etch pattern, forming an electrode layer on the second semiconductor layer, forming an insulative film on side surfaces of the first semiconductor layer, the light emitting layer, the second semiconductor layer, and the electrode layer, and separating, from the substrate, a light emitting element including the stack structure and the insulative film provided on a side surface of the stack structure. In the forming of the electrode layer, the electrode layer is etched such that the side surface of the electrode layer has a slope corresponding to an angle in a range of about 90 degrees to about 135 degrees with the substrate.

The forming of the electrode layer may include entirely forming the electrode layer on a surface of the substrate on which the stack structure may be formed, performing heat treatment on the electrode layer, and etching the heat-treated electrode layer.

A first surface of the electrode layer, which may be adjacent to the second semiconductor layer, and a second surface of the electrode layer, which faces the first surface, may be etched at different speeds by the heat treatment.

A width of the second surface of the electrode layer may be greater than or equal to a width of an upper surface of the second semiconductor layer, which contacts the first surface.

Specific details of other embodiments are included in the detailed description and drawings.

### Advantageous Effects

In accordance with the disclosure, a light emitting element is provided, which includes a first semiconductor layer, a light emitting layer, a second semiconductor layer, and an electrode layer, which are sequentially disposed and/or stacked on each other along a direction, and an insulative film surrounding side surfaces of the first semiconductor layer, the light emitting layer, the second semiconductor layer, and the electrode layer. A side surface of the electrode layer has a slope corresponding to an angle in a range of about 90 degrees to about 135 degrees. In accordance with the disclosure, a display device including the light emitting element and a method of fabricating the light emitting element are provided.

In accordance with the disclosure, the insulative film may be formed to have a sufficient thickness even at the periphery of the electrode layer. For example, the insulative film may be formed to have a sufficient thickness enough to include a margin for an over-etch which may occur in a subsequent process, at the periphery of the electrode layer and the second semiconductor layer adjacent to the electrode layer.

Accordingly, although the insulative film of the light emitting element is partially etched in a pixel process or the like, the insulative film can remain on a surface of the light emitting element while stably surrounding the second semiconductor layer. Thus, a short-circuit defect through the light emitting element can be prevented.

Effects according to the embodiments are not limited to the content exemplified above, and further various effects are included in the present specification.

### Description of Drawings

The above and other aspects and features of the disclosure will become more apparent by describing in detail embodiments thereof with reference to the attached drawings.
FIG. 1 is a perspective view schematically illustrating a light emitting element in accordance with an embodiment of the disclosure.
FIG. 2 is a sectional view schematically illustrating the light emitting element in accordance with an embodiment of the disclosure.
FIGS. 3 to 5 are sectional views each schematically illustrating a light emitting element in accordance with an embodiment of the disclosure.
FIG. 6 is a view schematically illustrating embodiments of a light emitting element.
FIGS. 7 to 17 are sectional views schematically illustrating a method of fabricating a light emitting element in accordance with an embodiment of the disclosure.
FIG. 18 is a plan view schematically illustrating a display device in accordance with an embodiment of the disclosure.
FIGS. 19 and 20 are circuit diagrams each schematically illustrating a pixel in accordance with an embodiment of the disclosure.
FIG. 21 is a plan view schematically illustrating a pixel in accordance with an embodiment of the disclosure.
FIG. 22 is a sectional view schematically illustrating a display device in accordance with an embodiment of the disclosure.
FIG. 23 is an enlarged schematic sectional view of an area of the pixel shown in FIG. 22.

### Modes of the Invention

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, sizes, thicknesses, ratios, and dimensions of the elements may be exaggerated for ease of description and for clarity. Like numbers refer to like elements throughout.

It will be understood that, although the terms "first," "second," etc. may be used herein to describe various elements, these elements should not be limited by these terms. These terms are only used to distinguish one element from another element. Thus, a "first" element discussed below could also be termed a "second" element without departing from the teachings of the disclosure.

As used herein, the singular forms are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

The terms "comprises," "comprising," "includes," and/or "including,", "has," "have," and/or "having," and variations thereof when used in this application, specify the presence of stated features, integers, steps, operations, elements, components, and/or groups thereof, but do not preclude the presence or addition of one or more other features, integers, steps, operations, elements, components, and/or groups thereof.

Further, an expression that an element such as a layer, region, substrate or plate is placed "on" or "above" another element indicates not only a case where the element is placed "directly on" or "just above" the other element but also a case where a further element is interposed between the element and the other element. An expression that an element such as a layer, region, substrate or plate is placed "beneath" or "below" another element indicates not only a case where the element is placed "directly beneath" or "just below" the other element but also a case where a further element is interposed between the element and the other element.

It will be understood that when an element is referred to as being "between" two elements, it can be the only element between the two elements, or one or more intervening elements may also be present. Like reference numerals refer to like elements throughout.

The effects and characteristics of the disclosure and a method of achieving the effects and characteristics will be clear by referring to the embodiments described below in detail together with the accompanying drawings. However, the disclosure is not limited to the embodiments disclosed herein but may be implemented in various forms.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

The terms "face" and "facing" mean that a first element may directly or indirectly oppose a second element. In a case in which a third element intervenes between the first and second element, the first and second element may be understood as being indirectly opposed to one another, although still facing each other.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

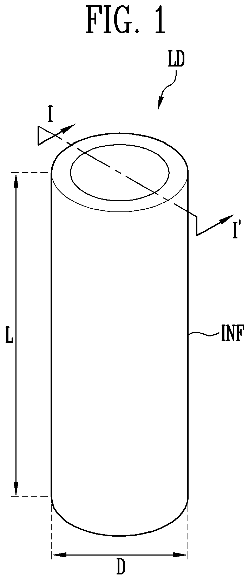

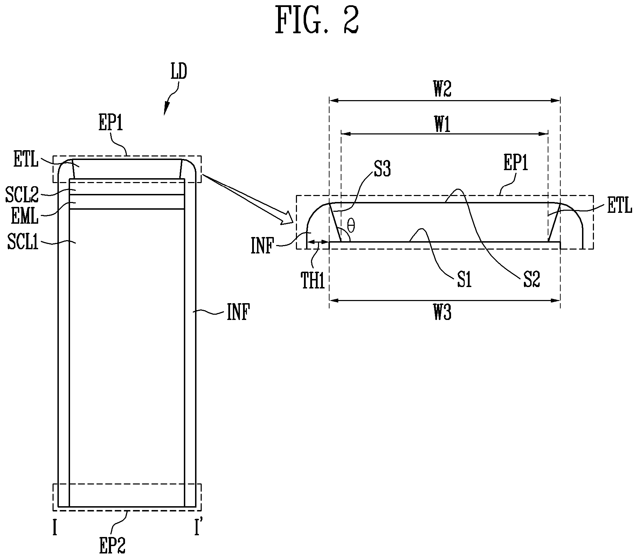

FIG. 1 is a perspective view schematically illustrating a light emitting element in accordance with an embodiment of the disclosure. FIG. 2 is a sectional view schematically illustrating the light emitting element in accordance with an embodiment of the disclosure. For example, FIG. 2 illustrates an embodiment of a section of a light emitting element LD, which corresponds to line I-I' shown in FIG. 1.

Referring to FIGS. 1 and 2, the light emitting element LD may include a first semiconductor layer SCL1, a light emitting layer EML, a second semiconductor layer SCL2, and an electrode layer ETL, which may be sequentially disposed and/or stacked on each other along a direction (e.g., a length direction or a thickness direction). In an embodiment, the light emitting element LD may further include at least one semiconductor layer (e.g., at least another semiconductor layer disposed on the top and/or the bottom of the light emitting layer EML) and/or at least one electrode layer (e.g., at least one electrode layer disposed at the periphery of the first semiconductor layer SCL1).

In an embodiment, the light emitting element LD may be provided in a rod shape. In description of an embodiment of the disclosure, the rod shape may include various forms of rod-like shapes or bar-like shapes, including a circular pillar shape, a polygonal pillar shape, and the like, and the shape of a section of the rod shape is not particularly limited. In an embodiment, a length L of the light emitting element LD may be greater than a diameter D (or a width of a cross-section) of the light emitting element LD.

The light emitting element LD may include a first end portion EP1 and a second end portion EP2, which face each other. For example, the light emitting element LD may include the first end portion EP1 and the second end portion EP2 at both ends thereof in the length direction (or thickness direction). The first end portion EP1 of the light emitting element LD may include a first base surface (e.g., an upper surface) of the light emitting element LD and/or a peripheral area thereof. The second end portion EP2 of the light emitting element LD may include a second base surface (e.g., a lower surface) of the light emitting element LD and/or a peripheral area thereof.

In an embodiment, the first semiconductor layer SCL1, the light emitting layer EML, the second semiconductor layer SCL2, and the electrode layer ETL may be sequentially disposed in a direction from the second end portion EP2 to the first end portion EP1 of the light emitting element LD. For example, the electrode layer ETL may be disposed at the first end portion EP1 of the light emitting element LD, and the first semiconductor layer SCL1 (or another electrode layer which may be adjacent to the first semiconductor layer SCL1 and may be electrically connected to the first semiconductor layer SCL1) may be disposed at the second end portion EP2 of the light emitting element LD.

The light emitting element LD may further include an insulative film INF surrounding side surfaces of the first semiconductor layer SCL1, the light emitting layer EML, and the second semiconductor layer SCL2. The insulative film INF may at least partially surround a side surface of the electrode layer ETL. For example, the insulative film INF may surround a portion of the electrode layer ETL at the first end portion EP1. In an example, the insulative film INF may surround a portion (e.g., a lower portion) of a side surface S3 of the electrode layer ETL, and may not surround another portion (e.g., an upper portion) of the side surface S3 of the electrode layer ETL.

The first semiconductor layer SCL1 may include a first conductivity type semiconductor layer including a first conductivity type dopant. For example, the first semiconductor layer SCL1 may be an N-type semiconductor layer including an N-type dopant.

In an embodiment, the first semiconductor layer SCL1 may include a nitride-based semiconductor material and/or a phosphide-based semiconductor material. In an example, the first semiconductor layer SCL1 may include a nitride-based semiconductor material including at least one material among GaN, AlGaN, InGaN, AlInGaN, AlN, and InN, or a phosphide-based semiconductor material including at least one material among GaP, GaInP, AlGaP, AlGaInP, AlP, and InP. In an embodiment, the first semiconductor layer SCL1 may include an N-type dopant such as Si, Ge and/or Sn. The material constituting the first semiconductor layer SCL1 is not limited thereto. The first semiconductor layer SCL1 may be formed by using various materials.

The light emitting layer EML (also, referred to as an "active layer") may be disposed on the first semiconductor layer SCL1. The light emitting layer EML may include a single- or multi-quantum well (QW) structure. In the case that a voltage which is a threshold voltage or higher is applied to both ends of the light emitting element LD, light may be emitted while electron-hole pairs may be recombined in the light emitting layer EML.

In an embodiment, the light emitting layer EML may emit light having a visible light wavelength band, e.g., light having a wavelength of about 400 nm to about 900 nm. For example, the light emitting layer EML may emit blue light, which has a wavelength in a range of about 450 nm to about 480 nm, green light, which has a wavelength in a range of about 480 nm to about 560 nm, or red light, which has a wavelength in a range of about 620 nm to about 750 nm. The color and/or wavelength band of light generated in the light emitting layer EML may be changed.

In an embodiment, the light emitting layer EML may include a nitride-based semiconductor material or a phosphide-based semiconductor material. In an example, the light emitting layer EML may include a nitride-based semiconductor material including at least one material among GaN, AlGaN, InGaN, InGaAlN, AlN, InN, and AlInN, or a phosphide-based semiconductor material including at least one material among GaP, GaInP, AlGaP, AlGaInP, AlP, and InP. The material constituting the light emitting layer EML is not limited thereto. The light emitting layer EML may be formed by using various materials.

In an embodiment, the light emitting layer EML may include an element involved in a color (or wavelength band) of light, and the color of light generated in the light emitting layer EML may be controlled by adjusting a content and/or a composition ratio of the element. In an embodiment, the light emitting layer EML may be formed as a multi-layer having a structure in which a GaN layer and an InGaN layer are alternately and/or repeatedly stacked on each other, and emit light of a specific color according to a content and/or a composition ratio of indium (In) included in the InGaN layer. Thus, the light emitting element LD of a desired color can be fabricated by adjusting the content and/or the composition ratio of indium (In) included in the light emitting layer EML.

The second semiconductor layer SCL2 may be disposed on the light emitting layer EML. The second semiconductor layer SCL2 may include a second conductivity type semiconductor layer including a second conductivity type dopant. For example, the second semiconductor layer SCL2 may be a P-type semiconductor layer including a P-type dopant.

In an embodiment, the second semiconductor layer SCL2 may include a nitride-based semiconductor material and/or a phosphide-based semiconductor material. In an example, the second semiconductor layer SCL2 may include a nitride-based semiconductor material including at least one material among GaN, AlGaN, InGaN, AlInGaN, AlN, and InN, or a phosphide-based semiconductor material including at least one material among GaP, GaInP, AlGaP, AlGaInP, AlP, and InP. In an embodiment, the second semiconductor layer SCL2 may include a P-type dopant such as Mg. The material constituting the second semiconductor layer SCL2 is not limited thereto. The second semiconductor layer SCL2 may be formed by using various materials.

In an embodiment, the first semiconductor layer SCL1 and the second semiconductor layer SCL2 include the same semiconductor material, and may include dopants of different conductivity types. In another embodiment, the first semiconductor layer SCL1 and the second semiconductor layer SCL2 include different semiconductor materials, and may include dopants of different conductivity types.

In an embodiment, the first semiconductor layer SCL1 and the second semiconductor layer SCL2 may have different lengths (or different thicknesses) in the length direction of the light emitting element LD. In an example, the first semiconductor layer SCL1 may have a length (or thickness) longer (or thicker) than a length (or thickness) of the second semiconductor layer SCL2 along the length direction of the light emitting element LD. Accordingly, the light emitting layer EML may be located closer to the first end portion EP1 (e.g., a P-type end portion) than the second end portion EP2 (e.g., an N-type end portion).

The electrode layer ETL may be disposed on the second semiconductor layer SCL2. For example, the electrode layer ETL may be directly formed on the second semiconductor layer SCL2 to be in contact with the second semiconductor layer SCL2 at a first surface S1 thereof.

The electrode layer ETL may constitute an electrode for protecting the second semiconductor layer SCL2 and smoothly connecting the second semiconductor layer SCL2 to an electrode, a line, or the like. For example, the electrode layer ETL may be an ohmic contact electrode or a Schottky contact electrode.

In an embodiment, the electrode layer ETL may include a metal or metal oxide. In an example, the electrode layer ETL may be formed of one or a mixture of a metal such as chromium (Cr), titanium (Ti), aluminium (Al), gold (Au), nickel (Ni) or copper (Cu), any oxide or alloy thereof, a transparent conductive material such as indium tin oxide (ITO), indium zinc oxide (IZO), indium tin zinc oxide (ITZO), zinc oxide (ZnO), tin dioxide (SnO₂) or indium oxide (In₂O₃), and the like. The material constituting the electrode layer ETL is not limited thereto. The electrode layer ETL may be formed by using various conductive materials.

In an embodiment, the electrode layer ETL may be substantially transparent. Accordingly, light generated in the light emitting element LD may be emitted from the first end portion EP1 of the light emitting element LD while being transmitted through the electrode layer ETL.

The electrode layer ETL may include the first surface S1 (e.g., a lower surface of the electrode layer ETL) and a second surface S2 (e.g., an upper surface of the electrode layer ETL), which face each other. Also, the electrode layer ETL may include a side surface S3 (also, referred to as a "third surface" of the electrode layer ETL) connecting the first surface S1 and the second surface S2 to each other.

In an embodiment, the first surface S1 and the second surface S2 of the electrode layer ETL may have different widths and/or different areas. For example, the second surface S2 of the electrode layer ETL may have a width and/or an area greater (e.g., wider) than the first surface S1 of the electrode layer ETL. In an example, the first surface S1 of the electrode layer ETL may have a first width W1, and the second surface S2 of the electrode layer ETL may have a second width W2 greater than the first width W1. The second surface S2 of the electrode layer ETL may have an area greater than an area of the first surface S1 of the electrode layer ETL.

In an embodiment, the width and/or the area of the second surface S2 of the electrode layer ETL may be greater than or equal to a width and/or an area of an upper surface of the second semiconductor layer SCL2, and the width and/or the area of the first surface S1 of the electrode layer ETL may be smaller than or equal to the width and/or the area of the upper surface of the second semiconductor layer SCL2. The upper surface of the second semiconductor layer SCL2 may be a surface in contact with the electrode layer ETL or the first surface S1 of the electrode layer ETL. For example, the second width W2 (or area) of the second surface S2 of the electrode layer ETL may be greater than a third width W3 (or area) of the upper surface of the second semiconductor layer SCL2, and the first width W1 (or area) of the first surface S1 of the electrode layer ETL may be smaller than or equal to the third width W3 (or area) of the upper surface of the second semiconductor layer SCL2. In another example, the second width W2 of the second surface S2 of the electrode layer ETL may be equal to the third width W3 of the upper surface of the second semiconductor layer SCL2, and the first width W1 of the first surface S1 of the electrode layer ETL may be smaller than the third width W3 of the upper surface of the second semiconductor layer SCL2.

In an embodiment, the side surface S3 of the electrode layer ETL may have a slope inclined by an angle θ in a range with respect to the first surface S1 of the electrode layer ETL (or a bottom surface of the light emitting element LD). For example, the side surface S3 of the electrode layer ETL may have a slope corresponding an angle θ in a range of about 90 degrees to about 135 degrees with respect to the first surface S1 of the electrode layer ETL. For example, the electrode layer ETL may have a reverse tapered sectional shape. In the case that the side surface S3 of the electrode layer ETL has a slope corresponding to an angle θ of about 115 degrees or more, the insulative film INF may be formed to have a sufficient thickness even at the first end portion EP1 and the periphery thereof (e.g., the periphery of the electrode layer ETL and the second semiconductor layer SCL2). Accordingly, although over-etch or the like may occur in a subsequent process, the insulative film INF can remain at the periphery of the second semiconductor layer SCL2 while completely surrounding the second semiconductor layer SCL2.

In an embodiment, the electrode layer ETL may have a thickness in a range of about 100 nm to about 200 nm. The thickness of the electrode layer ETL may be variously changed in some embodiments. In the case that the electrode layer ETL has a relatively small thickness (e.g., a thickness in the example range of 100 nm to 200 nm), a decrease in light emission efficiency of the light emitting element LD due to the provision of the electrode layer ETL can be prevented or minimized, and the electrode layer ETL can be more readily formed to have a desired shape. For example, in the case that the electrode layer ETL has a relatively small thickness, the electrode layer ETL may be readily patterned such that the side surface S3 of the electrode layer ETL has a slope corresponding to an angle θ in a range of about 90 degrees to about 135 degrees.

The insulative film INF may be provided on a surface of the light emitting element LD to surround side surfaces of the first semiconductor layer SCL1, the light emitting layer EML, the second semiconductor layer SCL2, and the electrode layer ETL.

In the case that the insulative film INF is provided on the surface of the light emitting element LD, a short-circuit defect through the light emitting element LD can be prevented. Accordingly, the electrical stability of the light emitting element LD can be ensured. Also, in the case that the insulative film INF is provided on the surface of the light emitting element LD, a surface defect of the light emitting element LD can be minimized, thereby improving the lifetime and efficiency of the light emitting element LD.

The insulative film INF may include a transparent insulating material. Accordingly, light generated in the light emitting layer EML can be emitted to the outside of the light emitting element LD while being transmitted through the insulative film INF. For example, the insulative film INF may include at least one insulating material among silicon oxide (SiOₓ) (e.g., SiO₂), silicon nitride (SiNₓ) (e.g., Si₃N₄), aluminium oxide (AlₓO_{y}) (e.g., Al₂O₃), titanium oxide (TiₓO_{y}) (e.g., TiO₂), and hafnium oxide (HfOₓ), or another insulating material.

The insulative film INF may be configured as a single layer or a multi-layer. In an example, the insulative film INF may be configured as a double layer.

The insulative film INF may expose the electrode layer ETL and the first semiconductor layer SCL1 (or another electrode layer provided at the second end portion EP2 of the light emitting element LD) at each of the first end portion EP1 and the second end portion EP2 of the light emitting element LD. For example, the insulative film INF may not be provided on the second surface S2 of the electrode layer ETL. Therefore, the insulative film INF may expose the second surface S2 of the electrode layer ETL at the first end portion EP1 of the light emitting element LD. Accordingly, the electrode layer ETL may be connected to at least one electrode, at least one line, and/or at least one conductive pattern, thereby applying a driving power source and/or a signal to the first end portion EP1 of the light emitting element LD. Also, the insulative film INF may not be provided on a lower surface of the first semiconductor layer SCL1 (e.g., the bottom surface of the light emitting element LD). Therefore, the insulative film INF may expose the lower surface of the first semiconductor layer SCL1 at the second end portion EP2 of the light emitting element LD. Accordingly, the first semiconductor layer SCL1 may be connected to at least one electrode, at least one line, and/or at least one conductive pattern, thereby applying a driving power source and/or a signal to the second end portion EP2 of the light emitting element LD.

The insulative film INF may completely surround at least side surfaces of the light emitting layer EML and the second semiconductor layer SCL2. Accordingly, the electrical stability of the light emitting element LD can be ensured, and a short-circuit defect through the light emitting element LD can be prevented.

In an embodiment, the insulative film INF may surround at least a portion of the side surface S3 of the electrode layer ETL. For example, the insulative film INF may surround the side surface S3 of the electrode layer ETL, which may be located at the periphery of the first surface S1 of the electrode layer ETL. In another example, the insulative film INF may surround a portion of the side surface S3 (e.g., a lower portion of the side surface S3) of the electrode layer ETL, which may be located at the periphery of the first surface S1 of the electrode layer ETL, and expose the second surface S2 of the electrode layer ETL and another portion of the side surface S3 (e.g., an upper portion of the side surface S3) of the electrode layer ETL, which may be located at the periphery of the second surface S2. In an example, in a process of removing the insulative film INF on the second surface S2 of the electrode layer ETL, the insulative film INF may be removed even at the upper portion of the side surface S3 of the electrode layer ETL, which may be located at the periphery of the second surface S2.

In an embodiment, except the electrode layer ETL, the insulative film INF may be formed to have an overall uniform thickness. For example, the insulative film INF may have a uniform thickness (e.g., a first thickness TH1) in the other area except the first end portion EP1. The insulative film INF may have a surface profile corresponding to a side surface shape of the first semiconductor layer SCL1, the light emitting layer EML, and the second semiconductor layer SCL2.

In an embodiment, the insulative film INF may have a surface profile different from a side surface shape of the electrode layer ETL (e.g., a side surface profile of the electrode layer ETL) at the first end portion EP1. For example, at the first end portion EP1, the insulative film INF may have a gradually changed thickness, and have a slope having an angle different from an angle of the slope of the side surface S3 of the electrode layer ETL. In an example, the insulative film INF may have a thickness increasing as becoming closer to the second semiconductor layer SCL2 at the first end portion EP1, and a thickness variation of the insulative film INF at the first end portion EP1 may be greater than a width variation of the electrode layer ETL according to a side surface slope of the electrode layer ETL.

For example, in the case that the insulative film INF is formed by using a Chemical Vapor Deposition (CVD) process, step coverage of the insulative film INF may be low as compared with the case that the insulative film INF is formed by using an Atomic Layer Deposition (ALD) process. Accordingly, the insulative film INF may have a surface profile different from the side surface profile of the electrode layer ETL at the first end portion EP1, and the like.

The thickness and/or the surface profile of the insulative film INF may vary in some embodiments. For example, the thickness and/or the surface profile of the insulative film INF may vary according to a process manner, a process condition, and/or a material, which are applied in the case that the insulative film INF is formed. In an embodiment, in the case that the insulative film INF is formed by using the ALD process or the like, through which a film having high step coverage can be formed, the insulative film INF may have a surface profile corresponding to a side surface shape (e.g., following the side surface shape) of the first semiconductor layer SCL1, the light emitting layer EML, the second semiconductor layer SCL2, and the electrode layer ETL, and be formed to have an overall uniform thickness.

In the case that the side surface S3 of the electrode layer ETL has a slope corresponding to the angle θ in the range of about 90 degrees to about 135 degrees, the insulative film INF may be formed to have a thickness sufficient to stably surround the second semiconductor layer SCL2 in an area corresponding to a contact surface between the electrode layer ETL and the second semiconductor layer SCL2.

In an example, the insulative film INF may be formed to have the first thickness TH1 of about 10 nm or more in an area surrounding the second semiconductor layer SCL2, the light emitting layer EML, and the first semiconductor layer SCL1, and have a thickness greater than the first thickness TH1 at a portion corresponding to the first surface S1 of the electrode layer ETL.

Also, the insulative film INF may be formed to have a thickness sufficient to remain on side surfaces of the second semiconductor layer SCL2 and the light emitting layer EML, even in the case that the insulative film INF is etched by a partial thickness at the periphery of the second semiconductor layer SCL2 and/or the light emitting layer EML due to over-etch which may occur in a process of etching the insulative film INF to expose the electrode layer ETL at the first end portion EP1 and/or another subsequent process (e.g., a pixel process for forming a pixel by using the light emitting element LD). For example, the insulative film INF may be formed to have a thickness (e.g., a thickness of about 10 nm or more) sufficient to stably surround the second semiconductor layer SCL2 and the light emitting layer EML, including a margin for an over-etch which may occur in a subsequent process.

In an embodiment, the light emitting element LD may have a small size in a range of nanometers to micrometers. For example, the light emitting element LD may have a diameter D (or a width of a cross-section) in the range of nanometers to micrometers. In an example, the light emitting element LD may have a diameter D and/or a length L in a range of about a few tens of nanometers to about a few tens of micrometers. However, the size of the light emitting element LD may be changed.

The structure, shape, size, and/or kind of the light emitting element LD may be changed in some embodiments. For example, the structure, shape, size, and/or kind of the light emitting element LD may be variously changed according to design conditions of a light emitting device using the light emitting element LD, light emission characteristics to be secured, or the like.

A light emitting device including the light emitting element LD may be used in various kinds of devices which require a light source. For example, light emitting elements LD may be disposed in a pixel of a display device, and be used as a light source of the pixel. The light emitting element LD may be used in other types of devices that require a light source, such as a lighting device.

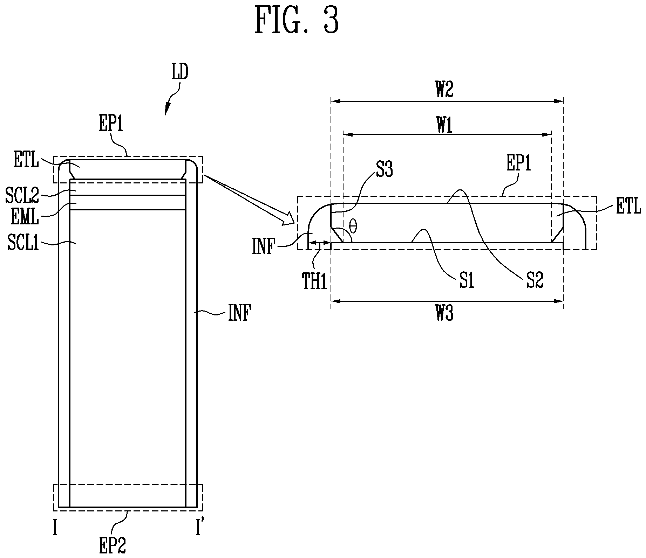

FIGS. 3 to 5 are sectional views each schematically illustrating a light emitting element in accordance with an embodiment of the disclosure. For example, FIGS. 3 to 5 illustrate different modifications of an embodiment shown in FIG. 2, in relation to the section of the light emitting element LD, which corresponds to the line I-I' shown in FIG. 1. In the embodiments shown in FIGS. 3 to 5, components similar or identical to those of the above-described embodiment are designated by like reference numerals, and overlapping descriptions will be omitted.

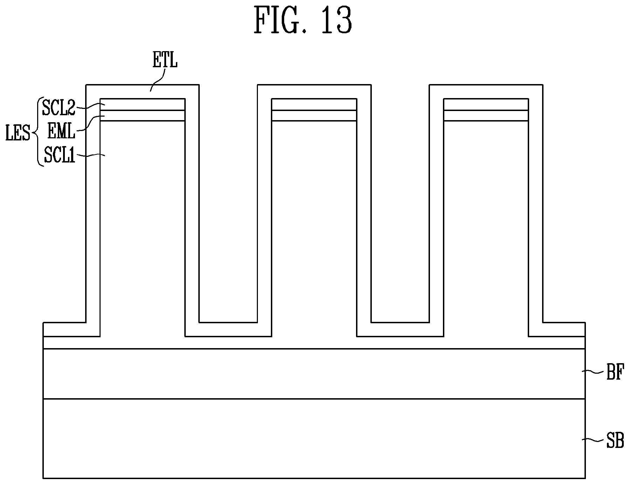

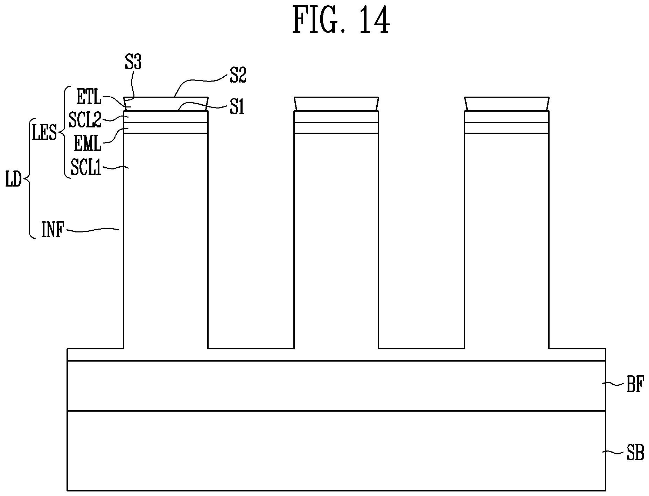

Referring to FIGS. 1 to 3, the electrode layer ETL may have a sectional shape of a polygon of which lower corner is chamfered, instead of a sectional shape of an inverted trapezoid. The electrode layer ETL and the second semiconductor layer SCL2 may have widths and/or surface areas, corresponding to each other, and a concave groove (or undercut) may be formed at the side surface S3 of the electrode layer ETL in a boundary area in which the electrode layer ETL and the second semiconductor layer SCL2 are in contact with each other. For example, in the boundary area in which the electrode layer ETL and the second semiconductor layer SCL2 are in contact with each other, the electrode layer ETL may have a partially reverse trapezoidal sectional shape. As will be described with reference to FIGS. 13 and 14, this is because, in a process of fabricating the light emitting element LD, heat treatment may be performed on the electrode layer ETL, and an upper portion (i.e., a portion adjacent to the second surface S2) of the electrode layer ETL, which may be exposed to the outside to be directly heat-treated, may not be relatively etched, but a lower portion (i.e., a portion adjacent to the first surface S1) of the electrode layer ETL, which may not be exposed to the outside, may be etched relatively rapidly. For example, since an etch rate (etch selectivity, or etching speed) varies for each position of the heat-treated electrode layer ETL, the concave groove (or undercut) may be formed in the electrode layer ETL.

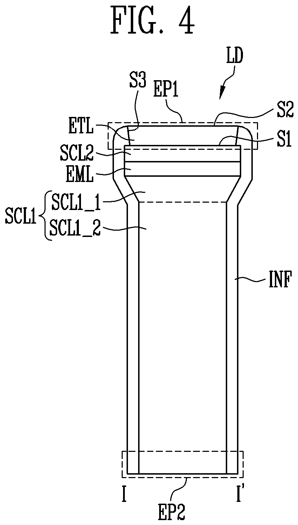

Referring to FIG. 4, the first semiconductor layer SCL1 may have a different width for each area and/or for each part. For example, the first semiconductor layer SCL1 may have an etch rate greater than an etch rate of the light emitting layer EML and/or the second semiconductor layer SCL2, and have a width and a sectional area in an area distant from the light emitting layer EML, which may be smaller than a width and a sectional area in an area close to the light emitting layer EML. In an example, the first semiconductor layer SCL1 may include a first part SCL1_1 adjacent to the light emitting layer EML and a second part SCL1_2 except the first part SCL1_1. The first semiconductor layer SCL1 may have a width and a sectional area at the first part SCL1_1, which may be greater than a width and a sectional area at the second part SCL1_2.

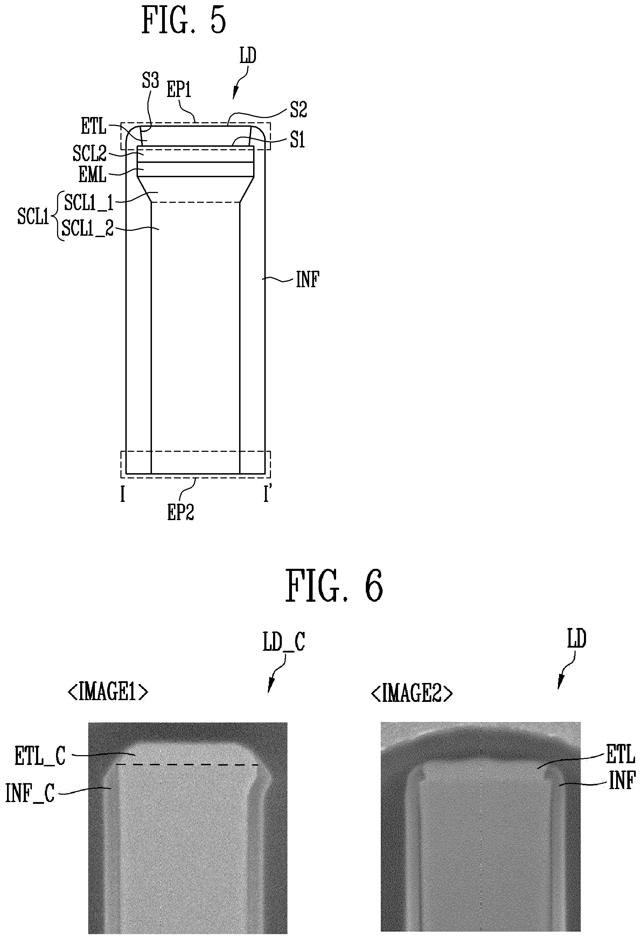

Referring to FIG. 5, in an embodiment in which the first semiconductor layer SCL1 has a width at the first part SCL1_1, which is greater than a width at the second part SCL1_2, the insulative film INF may not follow a surface profile of the first semiconductor layer SCL1 but may be formed to have a different thickness for each area and/or for each part. For example, the insulative film INF may have a surface profile substantially vertical to the bottom surface (e.g., the second end portion EP2) of the light emitting element LD, regardless of a width change of the first semiconductor layer SCL1, and have a thickness at a portion surrounding the second part SCL1_2 of the first semiconductor layer SCL1, which may be greater than a thickness at a portion surrounding the first part SCL1_1 of the first semiconductor layer SCL1.

In an embodiment, the insulative film INF may be formed by using a process representing a characteristic that step coverage is relatively low, or be formed to have a different thickness for each area and/or for each part by performing an additional process (e.g., a process of additionally forming the insulative film INF by a partial thickness with respect to a partial area or etching the insulative film INF by a partial thickness with respect to a partial area) after the insulative film INF may be primarily formed.

In the above-described embodiments, the side surface S3 of the electrode layer ETL may also have a slope in a range of about 90 degrees to about 135 degrees. Accordingly, the insulative film INF can be formed to have a sufficient thickness at the periphery of the electrode layer ETL including a boundary area between the electrode layer ETL and the second semiconductor layer SCL2. Accordingly, the insulative film INF can remain on the surface of the light emitting element LD while stably surrounding the second semiconductor layer SCL2 and the light emitting layer EML even in the case that the insulative film INF is partially etched in a subsequent process.

FIG. 6 is a view schematically illustrating embodiments of a light emitting element.

Referring to FIGS. 1 to 6, a first image IMAGE1 represents a light emitting element LD_C in accordance with a comparative embodiment, and a second image IMAGE2 represents the light emitting element LD in accordance with an embodiment shown in FIGS. 1 and 2.

An electrode layer ETL_C of the light emitting element LD_C represented in the first image IMAGE1 has a slope smaller than 90 degrees. An insulative film INF_C of the light emitting element LD_C may be formed by depositing the insulative film INF_C with a constant thickness to cover the electrode layer ETL_C and removing the insulative film INF_C located on an upper surface of the electrode layer ETL_C through etching. In the case that over-etch occurs in the process of forming the insulative film INF, particularly, in the case that over-etch occurs in an area adjacent to the upper surface of the electrode layer ETL_C, the insulative film INF_C may be formed with a thin thickness in a circumferential area of the electrode layer ETL_C of the light emitting element LD_C. In some cases, the second semiconductor layer SCL2 (see FIG. 2) (and the light emitting layer EML (see FIG. 2)) on the bottom of the electrode layer ETL_C may be exposed. A short-circuit defect caused by the light emitting element LD_C may occur.

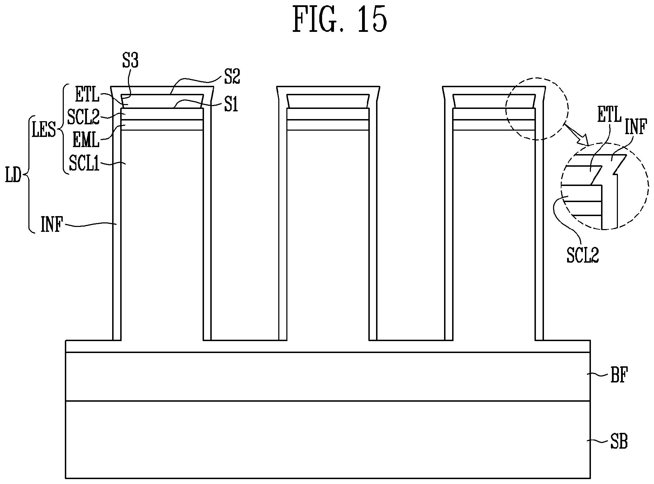

The electrode layer ETL of the light emitting element LD represented in the second image IMAGE2 may have a slope greater than 90 degrees. Although over-etch may occur in a process of fabricating the light emitting element LD, e.g., a process of forming the insulative film INF (see FIG. 15), the insulative film INF may be formed with a sufficient thickness in a circumferential area of the electrode layer ETL of the light emitting element LD. Thus, a short-circuit defect due to exposure of the second semiconductor layer SCL2 (see FIG. 2) (e.g., a short-circuit defect which may occur through the second semiconductor layer SCL2) can be prevented.

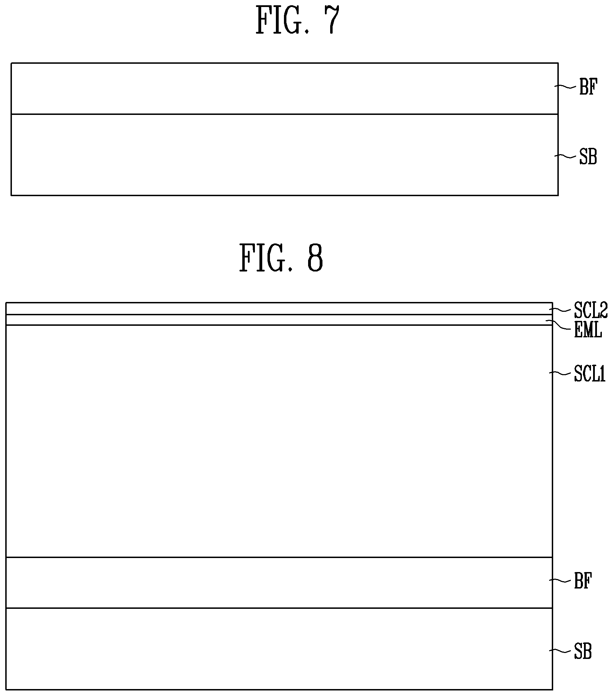

FIGS. 7 to 17 are sectional views schematically illustrating a method of fabricating a light emitting element in accordance with an embodiment of the disclosure. For example, FIGS. 7 to 17 sequentially illustrate a method of fabricating the light emitting element LD in accordance with an embodiment shown in FIGS. 1 and 2. The light emitting elements LD in accordance with the embodiments shown in FIGS. 3 to 5 may be fabricated through a fabricating method identical or similar to the fabricating method of the light emitting elements LD in accordance with an embodiment shown in FIGS. 1 and 2. In FIGS. 7 to 17, an embodiment in which multiple light emitting elements LD are fabricated on one substrate SB is illustrated.

First, referring to FIGS. 1 to 7, a substrate SB (also, referred to as a "growth substrate" or a "fabrication substrate") may be prepared.

The substrate SB may be a substrate for fabrication, a wafer, or the like, which may be suitable for epitaxial growth (or epitaxy) of a semiconductor. For example, the substrate SB may be a substrate including a material such as silicon (Si), sapphire, SiC, GaN, GaAs and/or ZnO. The substrate SB may include various kinds of substrates and/or substrates including various materials. For example, in the case that epitaxial growth for fabricating light emitting elements LD is smoothly made, the kind or material of the substrate SB is not particularly limited. After the substrate SB is used as a substrate for epitaxial substrate for fabrication of light emitting elements LD, the substrate SB may be finally separated from the light emitting elements LD.

In an embodiment, a buffer layer BF may be formed on the substrate SB. The buffer layer BF may be formed on the substrate SB through epitaxial growth, and be finally separated from the light emitting elements LD. The buffer layer BF may be located between light emitting elements LD and the substrate SB in a process of fabricating the light emitting elements LD, thereby allowing the light emitting elements LD and the substrate SB to be physically spaced apart from each other. In an embodiment, the buffer layer BF may include an intrinsic semiconductor layer undoped with an impurity, and include the same semiconductor material as a first semiconductor layer SCL1 (see FIG. 8). In an embodiment, the buffer layer BF may include multi-layer semiconductor layers. One of the multi-layer semiconductor layers may be an intrinsic semiconductor layer. Another of the multi-layer semiconductor layers may be a semiconductor layer doped to include a first or second conductivity type dopant, and reduce strain between the substrate SB and the first semiconductor layer SCL1.

Referring to FIG. 8, the first semiconductor layer SCL1, a light emitting layer EML, and a second semiconductor layer SCL2 may be sequentially formed on the substrate SB. For example, on the substrate SB on which the buffer layer BF is formed, the first semiconductor layer SCL1, the light emitting layer EML, and the second semiconductor layer SCL2 may be sequentially formed through epitaxial growth.

The first semiconductor layer SCL1 may be formed of the material of the first semiconductor layer SCL1, which is disclosed in an embodiment shown in FIGS. 1 and 2, or another semiconductor material. The first semiconductor layer SCL1 may be doped to include an N-type dopant such as Si, Ge and/or Sn.

The first semiconductor layer SCL1 may be formed through epitaxial growth using a process such as Metal-Organic Vapor Phase Epitaxy (MOVPE), Metal-Organic Chemical Vapor Deposition (MOCVD), Molecular Beam Epitaxy (MBE), Liquid Phase Epitaxy (LPE), and/or Vapor Phase Epitaxy (VPE), but the method of forming the first semiconductor layer SCL1 is not limited thereto.

The light emitting layer EML may be formed of the material of the light emitting layer EML, which is disclosed in an embodiment shown in FIGS. 1 and 2, or another semiconductor material. In an embodiment, the light emitting layer EML may be formed through epitaxial growth using a process such as MOVPE, MOCVD, MBE, LPE or VPE, but the method of forming the light emitting layer EML is not limited thereto.

The second semiconductor layer SCL2 may be formed of the material of the second semiconductor layer SCL2, which is disclosed in an embodiment shown in FIGS. 1 and 2, or another semiconductor material. The second semiconductor layer SCL2 may be doped to include a P-type dopant such as Mg. In an embodiment the second semiconductor layer SCL2 may be formed through epitaxial growth using a process such as MOVPE, MOCVD, MBE, LPE and/or VPE, but the method of forming the second semiconductor layer SCL2 is not limited thereto.

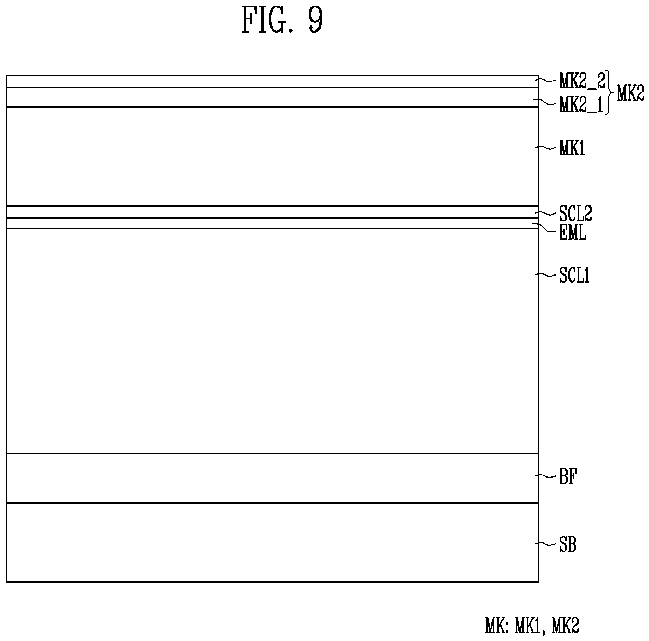

Referring to FIGS. 9 to 12, a multi-layer stack structure LES (also, referred to as a "light emitting stack structure" or a "light emitting core") including the first semiconductor layer SCL1, the light emitting layer EML, and the second semiconductor layer SCL2 may be patterned in a rod shape by etching the first semiconductor layer SCL1, the light emitting layer EML, and the second semiconductor layer SCL2 in a direction substantially vertical to the substrate SB. Accordingly, a light emitting element LD having a rod shape can be fabricated.

In an embodiment, the light emitting element LD may be patterned through a patterning process using a nano imprint lithography process, a photolithography process, and/or the like. In an example, the light emitting element LD may be patterned by using the nano imprint lithography process.

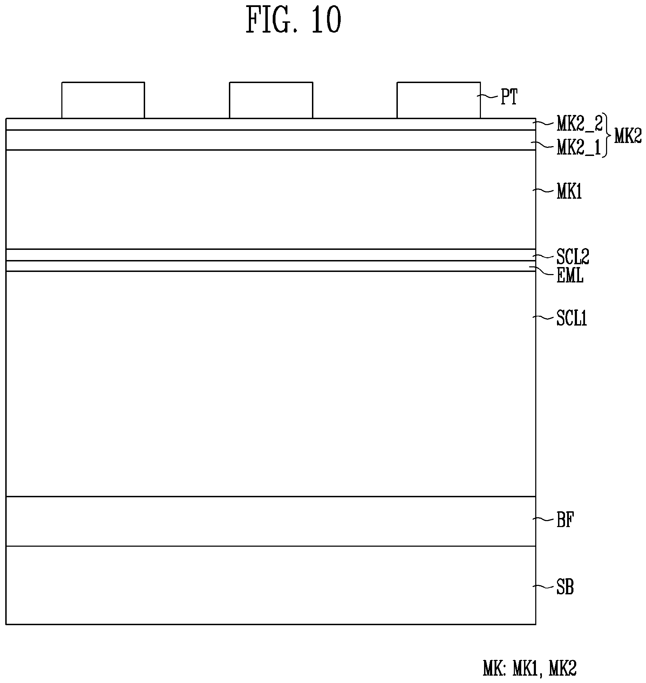

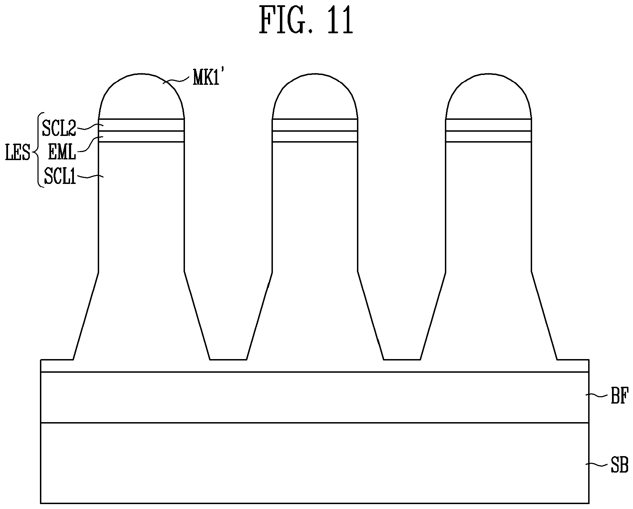

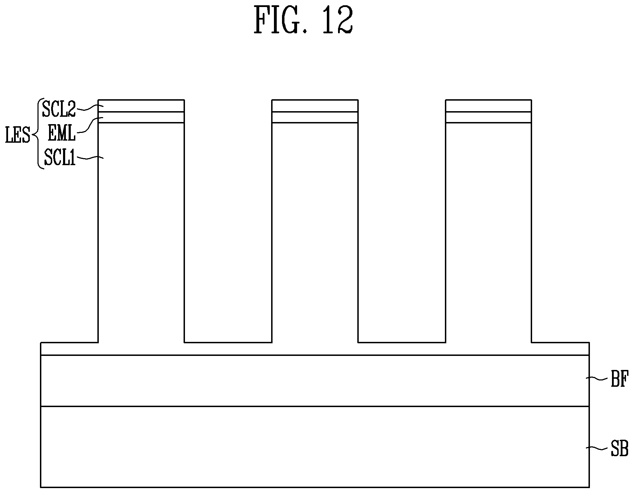

For example, after a mask layer MK is formed on the second semiconductor layer SCL2 as shown in FIG. 9, etch patterns PT (e.g., nano patterns) may be formed on the mask layer MK as shown in FIG. 10. Subsequently, the stack structure LES including the first semiconductor layer SCL1, the light emitting layer EML, and the second semiconductor layer SCL2 may be etched in a desired shape such as a rod shape through an etching process using the mask layer MK and the etch patterns PT. For example, the first semiconductor layer SCL1, the light emitting layer EML, and the second semiconductor layer SCL2 may be etched in a vertical direction by performing a dry etching process using the mask layer MK and the etch patterns PT, so that the stack structure LES including the first semiconductor layer SCL1, the light emitting layer EML, and the second semiconductor layer SCL2 may be etched in an approximately rod shape as shown in FIG. 11. Subsequently, each stack structure LES primarily etched may be patterned in a rod shape as shown in FIG. 12 by performing an additional etching process (e.g., a wet etching process or the like).

In an embodiment, the mask layer MK may include at least two mask layers formed of different materials for the purpose of a selective dry etching for each layer and/or for each film, which may be performed in a subsequent process. For example, a first mask layer MK1 (e.g., a first hard mask layer) including an insulating material may be first formed on the second semiconductor layer SCL2, and a second mask layer MK2 (e.g., a second hard mask layer) including a conductive material may be formed on the first mask layer MK1.

The first mask layer MK1 may include silicon oxide (SiOₓ) (e.g., SiO₂), silicon nitride (SiNₓ), silicon oxynitride (SiOₓN_{y}), and/or another insulating material.

The second mask layer MK2 may include at least one metal among aluminium (Al), titanium (Ti), and chromium (Cr), or another metal. In an embodiment, the second mask layer MK2 may include multi-layer metal layers MK2_1 and MK2_2 including different metals. For example, the second mask layer MK2 may include a first metal layer MK2_1 including titanium (Ti) and a second metal layer MK2_2 including aluminium (Al). The material and stacked structure of the second mask layer MK2 are not particularly limited. For example, any material may be used as the material of the second mask layer MK2 as long as it is a material capable of serving as a mask to perform continuous etching of the first semiconductor layer SCL1, the light emitting layer EML, and the second semiconductor layer SCL2. Also, the second mask layer MK2 may be formed as a single layer or a multi-layer. As the second mask layer MK2 is formed, the second mask layer MK2 may protect the first mask layer MK1 in the case that the etch patterns PT are removed in a subsequent process.

The etch patterns PT may be disposed on the mask layer MK to be spaced apart from each other. In order for the etch patterns PT to respectively pattern light emitting elements LD on the substrate SB, the etch patterns PT may be formed to have a shape, a size, and/or a distance, corresponding to the light emitting elements LD. For example, the etch patterns PT may have a shape and size, which correspond to the shape and diameter of light emitting elements LD to be fabricated, and be spaced apart from each other at a distance enough to allow the light emitting elements LD to be readily separated from each other.

The etch patterns PT may include polymer or another material. In an embodiment, the etch patterns PT may include nano imprint resin, and be formed by using a nano imprint lithography process.

In an embodiment, the first semiconductor layer SCL1, the light emitting layer EML, and the second semiconductor layer SCL2 may be primarily etched through a stepwise dry etching process using the etch patterns PT. For example, the second mask layer MK2 may be first etched by using the etch patterns PT, and the first mask layer MK1 may be etched. After the first mask layer MK1 is etched, the second semiconductor layer SCL2, the light emitting layer EML, and the first semiconductor layer SCL1 may be continuously etched. In an embodiment, the second semiconductor layer SCL2, the light emitting layer EML, and the first semiconductor layer SCL1 may be etched in a substantially vertical direction through a dry etching process, to have an approximately rod shape as shown in FIG. 11. First mask patterns MK1' formed by etching the first mask layer MK1 in patterns corresponding to the etch patterns PT may remain on an electrode layer ETL even after the dry etching process on the second semiconductor layer SCL2, the light emitting layer EML, and the first semiconductor layer SCL1 may be completed.

Subsequently, the stack structure LES including the first semiconductor layer SCL1, the light emitting layer EML, and the second semiconductor layer SCL2 may be etched in a rod shape by performing an additional etching process such as a wet etching process.

The mask layer MK, the etch patterns PT, and/or the first mask patterns MK1' may be removed after etching processes respectively using the mask layer MK, the etch patterns PT, and/or the first mask patterns MK1' may be completed.

Referring to FIG. 13, the electrode layer ETL may be entirely formed on one surface (e.g., an upper surface) of the substrate SB including the stack structures LES having the rod shape. The electrode layer ETL may be formed by using an ALD process, a CVD process, and/or the like, but the method of forming the electrode layer ETL is not limited thereto. In an embodiment, the electrode layer ETL may be formed of the material of the electrode layer ETL, which is disclosed in an embodiment shown in FIGS. 1 and 2, or another conductive material.

Subsequently, heat treatment on the electrode layer ETL may be performed. An upper surface of the electrode layer ETL, which is exposed to the outside, may become harder than the inside of the electrode layer ETL. For example, as the electrode layer ETL becomes more distant from the stack structures LES (or the second semiconductor layer SCL2), the electrode layer ETL may become harder, and the etch rate of the electrode layer ETL with respect to wet etching such as a buffered oxide etchant (BOE) may become lower.

Subsequently, a side portion of the electrode layer ETL may be etched by performing a wet etching process, so that the electrode layer ETL remains on only the top of the second semiconductor layer SCL2 as shown in FIG. 14. A mask or the like may be used for etching (and heat treatment) on the electrode layer ETL, but the disclosure is not limited thereto. Since an etch rate for each position of the electrode layer ETL varies due to the heat treatment, an upper portion including a second surface S2 of the electrode layer ETL may be etched relatively slowly or may not be etched as compared with a lower portion including a first surface S1 of the electrode layer ETL. Accordingly, the electrode layer ETL may have a reverse trapezoidal sectional shape. A side surface S3 of the electrode layer ETL may have a slope in a range of about 90 degrees to about 135 degrees.

Referring to FIG. 15, an insulative film INF may be entirely formed on the surface (e.g., the upper surface) of the substrate SB including the stack structures LES having the rod shape. The insulative film INF may be formed to have a uniform thickness from surfaces of the stack structures LES (or the electrode layer ETL and the second semiconductor layer SCL2). In an embodiment, the insulative film INF may be formed of the material of the insulative film INF, which is disclosed in an embodiment shown in FIGS. 1 and 2, or another insulating material. In an embodiment, the insulative film INF may be formed by using an ALD process, a CVD process, and/or the like, but the method of forming the insulative film INF is not limited thereto.

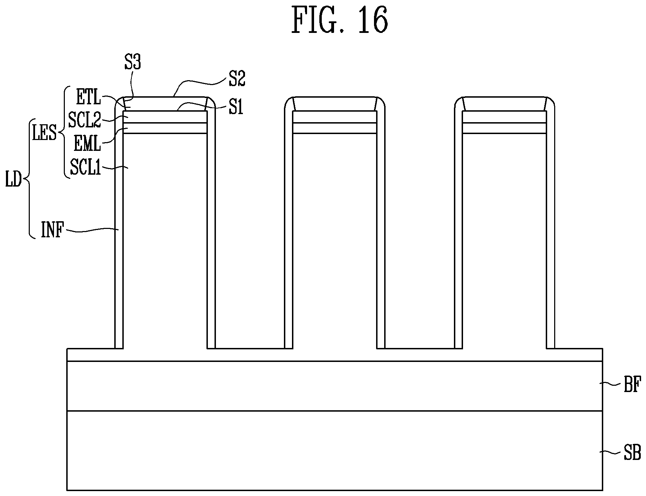

Referring to FIG. 16, the insulative film INF may be etched such that the second surface S2 of the electrode layer ETL is exposed. Accordingly, the insulative film INF may be formed on a side surface of each of the stack structures LES having the rod shape (e.g., side surfaces of the first semiconductor layer SCL1, the light emitting layer EML, the second semiconductor layer SCL2, and the electrode layer ETL, which constitute each rod-shaped stack structure LES), and the electrode layer ETL may be exposed at an upper surface of each of the stack structures LES. Accordingly, each light emitting element LD can be fabricated, which includes each stack structure LES and the insulative film INF provided on the side surfaces of the stack structure LES.

In the process of etching the insulative film INF, the insulative film INF may be partially etched even on the side surface S3 of the electrode layer ETL. For example, the thickness of the insulative film INF may become thinner as it becomes closer to the second surface S2 of the electrode layer ETL along the side surface S3 of the electrode layer ETL. For example, the insulative film INF may be partially etched and removed at an upper portion of the side surface S3 of the electrode layer ETL.

In an embodiment, in the case that the electrode layer ETL is formed such that the side surface S3 of the electrode layer ETL has a slope corresponding to an angle in a range of about 90 degrees to about 135 degrees, etching of the insulative film INF on the side surface S3 of the electrode layer ETL during the process of etching the insulative film INF so as to expose the second surface S2 of the electrode layer ETL can be prevented or minimized. Accordingly, the insulative film INF can remain to have a sufficient thickness in an area corresponding to a contact surface between the electrode layer ETL and the second semiconductor layer SCL2 (e.g., an area surrounding the first surface S1 of the electrode layer ETL or the circumference at the periphery thereof). In an example, the insulative film INF may remain to have a thickness of about 10 nm or more in the area corresponding to the contact surface between the electrode layer ETL and the second semiconductor layer SCL2. Accordingly, the insulative film INF can stably surround the second semiconductor layer SCL2 and the like.

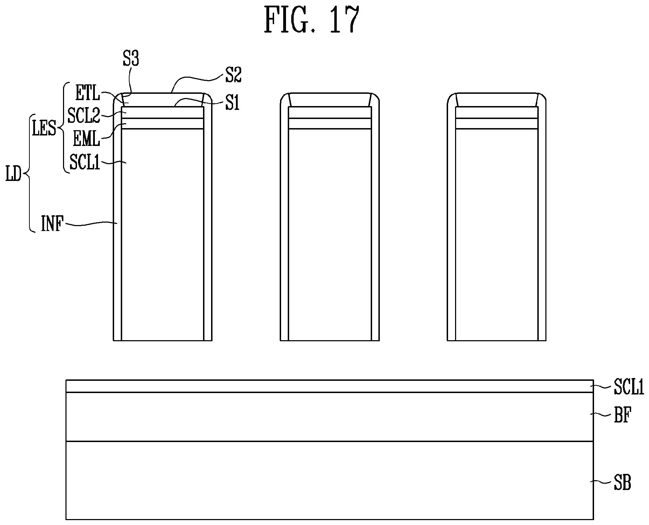

Referring to FIG. 17, the light emitting elements LD may be separated from the substrate SB. In an embodiment, the light emitting elements LD may be separated from the substrate SB through an electrical and/or chemical etching process or another process.

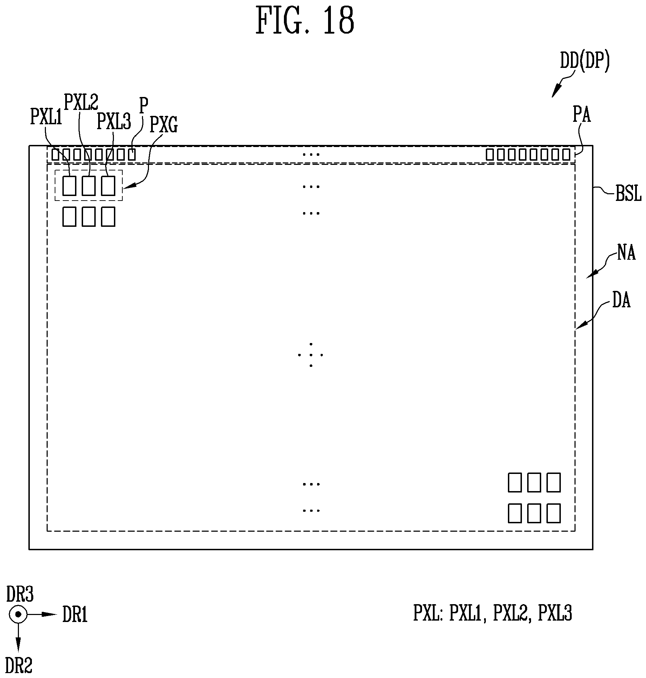

FIG. 18 is a plan view schematically illustrating a display device in accordance with an embodiment of the disclosure. In FIG. 18, a structure of a display device DD will be briefly illustrated based on a display panel DP including a display area DA. The display device DD may further include a driving circuit (e.g., a scan driver, a data driver, a timing controller, and the like) for driving pixels PXL.

Referring to FIG. 18, the display device DD may include a base layer BSL and pixels PXL disposed on the base layer BSL. The base layer BSL and the display device DD including the same may be provided in various shapes. For example, the base layer BSL and the display device DD may be provided in the form of a plate having a substantially quadrangular shape in plan view, and include an angular or round corner portion. The shape of the base layer BSL and the display device DD may be changed. In an example, in plan view, the base layer BSL and the display device DD may have another polygonal shape such as a hexagonal shape or an octagonal shape, or have a shape including a curved side such as a circular shape or an elliptical shape.

In FIG. 18, it is illustrated that the display device DD has the form of a plate having a quadrangular shape. A lateral direction (e.g., a row direction or a horizontal direction) of the display device DD may be defined as a first direction DR1, a longitudinal direction (e.g., a column direction or a vertical direction) of the display device DD may be defined as a second direction DR2, and a thickness direction (or height direction) of the display device DD may be defined as a third direction DR3.

The base layer BSL may be a base member for constituting the display device DD. For example, the base layer BSL may constitute a base surface of the display device DD.

The base layer BSL and the display device DD including the same may include a display area DA for displaying an image and a non-display area NA located at the periphery of the display area DA.

The display area DA may be an area in which the pixels PXL may be disposed, and may be an area in which an image may be displayed by the pixels PXL. In an embodiment, the display area DA may be disposed in a central area of the base layer BSL and the display device DD (e.g., a central area of the display panel DP).

The display area DA may have various shapes. For example, the display area DA may have various shapes including a rectangular shape, a circular shape, an elliptical shape, and the like. In an embodiment, the display area DA may have a shape corresponding to the shape of the base layer BSL, but the disclosure is not limited thereto.

The non-display area NA may be another area except the display area DA. In an embodiment, the non-display area NA may be located in an edge area of the base layer BSL and the display device DD to surround the display area DA. A portion of the non-display area NA may be a pad area PA in which pads P may be disposed.

The pixels PXL may be disposed in the display area DA. In an example, the display area DA may include multiple pixel areas in which the pixels PXL may be respectively provided and/or disposed.

In an embodiment, at least two kinds of pixels PXL for emitting lights of different colors may be disposed in the display area DA. In an example, first color pixels PXL1, second color pixels PXL2, and third color pixels PXL3 may be arranged in the display area DA. At least one first color pixel PXL1, at least one second color pixel PXL2, and at least one third color pixel PXL3, which may be disposed adjacent to each other, may constitute one pixel group PXG. Luminances of first, second, and third color pixels PXL1, PXL2, and PXL3 included in each pixel group PXG may be individually controlled, thereby variously changing the color of light emitted from the pixel group PXG.

In an embodiment, a first color pixel PXL1, a second color pixel PXL2, and a third color pixel PXL3, which may be consecutively arranged along the first direction DR1, may constitute one pixel group PXG. The number, kind, and/or arrangement structure of pixels PXL constituting each pixel group PXG may be variously changed.

In an embodiment, the first color pixel PXL1 may be a red pixel for emitting red light, and the second color pixel PXL2 may be a green pixel for emitting green light. The third color pixel PXL3 may be a blue pixel for emitting blue light. The color of light emitted from pixels PXL constituting each pixel group PXG may be variously changed.

In an embodiment, each pixel PXL may include at least one light emitting element LD. For example, the pixel PXL may include the light emitting element LD in accordance with at least one embodiment among the embodiments shown in FIGS. 1 to 5. In an example, the pixel PXL may include a light emitting element LD including a first semiconductor layer SCL1, a light emitting layer EML, a second semiconductor layer SCL2, an electrode layer ETL, and an insulative film INF, and the electrode layer ETL may include a side surface S3 having a slope in a range of about 90 degrees to about 135 degrees. In an embodiment, each light emitting element LD may have a size in a range of about nanometers to micrometers and have a rod shape. However, the disclosure is not limited thereto. For example, the number, kind, and/or size of light emitting elements LD provided in each pixel PXL may be changed in some embodiments.

In an embodiment, the first color pixel PXL1, the second color pixel PXL2, and the third color pixel PXL3 may have, as light sources, first, second, and third color light emitting elements LD, respectively. Accordingly, the first color pixel PXL1, the second color pixel PXL2, and the third color pixel PXL3 can emit light of a first color, light of a second color, and light of a third color, respectively.

In another embodiment, the first color pixel PXL1, the second color pixel PXL2, and the third color pixel PXL3 may include light emitting elements LD emitting light of the same color, and a light conversion layer including wavelength conversion particles (e.g., particles for converting a color and/or a wavelength of light, such as a quantum dot QD) may be disposed in light emission areas of the first color pixel PXL1, the second color pixel PXL2, and/or the third color pixel PXL3. Accordingly, the first color pixel PXL1, the second color pixel PXL2, and the third color pixel PXL3 can emit light of the first color, light of the second color, and light of the third color, respectively.

For example, the first color pixel PXL1, the second color pixel PXL2, and the third color pixel PXL3 may include blue light emitting elements. A light conversion layer including wavelength conversion particles (e.g., a red quantum dot) of the first color may be disposed in a light emission area of the first color pixel PXL1, and a light conversion layer including wavelength conversion particles (e.g., a green quantum dot) of the second color may be disposed in a light emission area of the second color pixel PXL2. Accordingly, the first color pixel PXL1 can emit light of the first color (e.g., red light), and the second color pixel PXL2 can emit light of the second color (e.g., green light).

The pixels PXL may have a structure in accordance with at least one embodiment among embodiments to be described below. For example, the pixels PXL may have a structure to which any one embodiment among the embodiments which will be described later or have a structure to which a combination of at least two embodiments is applied.

In an embodiment, the pixel may be configured as an active pixel, but the disclosure is not limited thereto. For example, in another embodiment, the pixel PXL may be configured as a passive pixel.

Lines and/or a built-in circuit, connected to the pixels PXL of the display area DA, may be disposed in the non-display area NA. A portion of the non-display area NA may be set as the pad area PA, and the pads P may be disposed in the pad area PA. The pads P may include signal pads to which various driving signals necessary for driving of the pixels PXL are applied, and/or power pads to which power sources are applied.

In an embodiment, the non-display area NA may have a narrow width. In an example, the non-display area NA may have a width of about 100 µm or less. Accordingly, the display device DD can be implemented as a bezel-less display device.

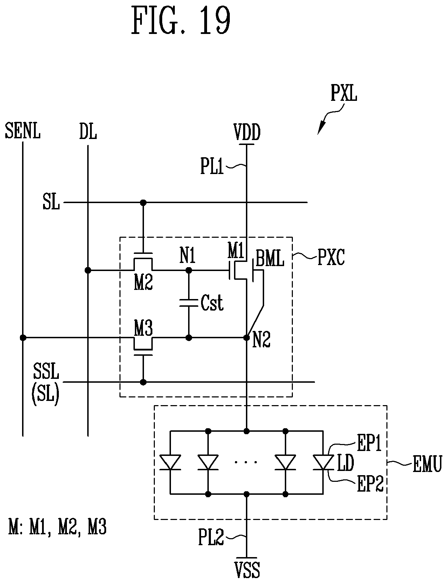

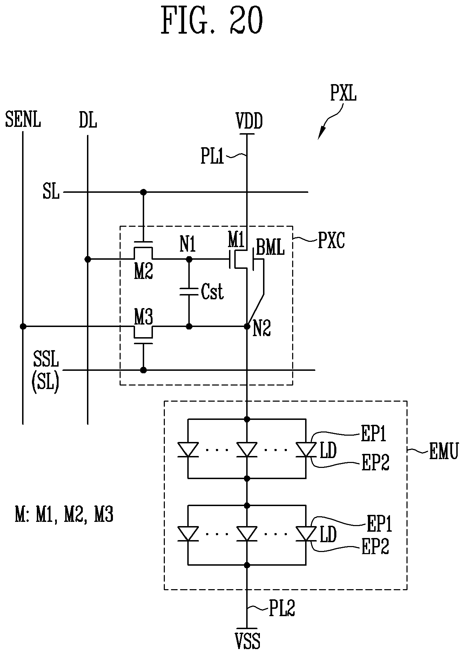

FIGS. 19 and 20 are circuit diagrams each schematically illustrating a pixel in accordance with an embodiment of the disclosure. For example, FIGS. 19 and 20 illustrate pixels PXL including light emitting units EMU having different structures.

In some embodiments, each pixel PXL shown in FIGS. 19 and 20 may be any one of the pixels PXL disposed in the display area DA shown in FIG. 18. The pixels PXL may have structures substantially identical or similar to one another.

Referring to FIGS. 19 and 20, the pixel PXL may be connected to a scan line SL (also, referred to as a "first scan line"), a data line DL, a first power line PL1, and a second power line PL2. Also, the pixel PXL may be further connected to at least another power line and/or at least another signal line. For example, the pixel PXL may be further connected to a sensing line SENL (also, referred to as an "initialization power line") and/or a control line SSL (also, referred to as a "second scan line").

The pixel PXL may include a light emitting unit EMU for generating light with a luminance corresponding to each data signal. Also, the pixel PXL may further include a pixel circuit PXC for driving the light emitting unit EMU.

The pixel circuit PXC may be connected to the scan line SL and the data line DL, and be connected between the first power line PL1 and the light emitting unit EMU. For example, the pixel circuit PXC may be electrically connected to the scan line SL to which a first scan signal may be supplied, the data line DL to which a data signal may be supplied, the first power line PL1 to which a voltage of a first power source VDD may be applied, and the light emitting unit EMU.

The pixel circuit PXC may be selectively further connected to the control line SSL to which a second scan signal may be supplied, and the sensing line SENL connected to a reference power source (or initialization power source) or a sensing circuit, corresponding to a display period or a sensing period. In an embodiment, the second scan signal may be a signal identical to or different from the first scan signal. In the case that the second scan signal is a signal identical to the first scan signal, the control line SSL may be integrated with the scan line SL.

The pixel circuit PXC may include at least one transistor M and a capacitor Cst. For example, the pixel circuit PXC may include a first transistor M1, a second transistor M2, a third transistor M3, and a capacitor Cst.

The first transistor M1 may be connected between the first power line PL1 and a second node N2. The second node N2 may be a node at which the pixel circuit PXC and the light emitting unit EMU may be connected to each other. For example, the second node N2 may be a node at which one electrode (e.g., a source electrode) of the first transistor M1 and the light emitting unit EMU may be electrically connected to each other. A gate electrode of the first transistor M1 may be connected to a first node N1. The first transistor M1 may control a driving current supplied to the light emitting unit EMU, corresponding to a voltage of the first node N1. For example, the first transistor M1 may be a driving transistor of the pixel PXL.

In an embodiment, the first transistor M1 may further include a bottom metal layer BML (also referred to as a "back-gate electrode" or a "second gate electrode"). In an embodiment, the bottom metal layer BML may be electrically connected to the one electrode (e.g., the source electrode) of the first transistor M1.

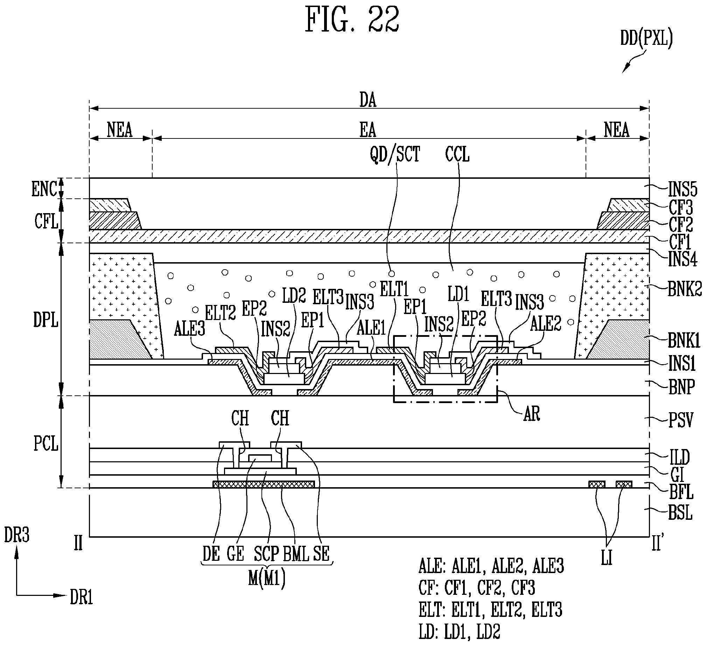

In an embodiment in which the first transistor M1 includes the bottom metal layer BML, a back-biasing technique (or sync technique) may be applied, in which a threshold voltage of the first transistor M1 may be moved in a negative direction or positive direction by applying a back-biasing voltage to the bottom metal layer BML of the first transistor M1. In addition, in the case that the bottom metal layer BML is disposed on the bottom of a semiconductor pattern (e.g., a semiconductor pattern SCP shown in FIG. 22) constituting a channel of the first transistor M1, light incident onto the semiconductor pattern may be blocked, thereby stabilizing an operating characteristic of the first transistor M1.

The second transistor M2 may be connected between the data line DL and the first node N1. A gate electrode of the second transistor M2 may be connected to the scan line SL. The second transistor M2 may be turned on in the case that the first scan signal having a gate-on voltage (e.g., a logic high voltage or high level voltage) is supplied from the scan line SL, to electrically connect the data line DL and the first node N1.

A data signal of a corresponding frame may be supplied to the data line DL for each frame period. The data signal may be transferred to the first node N1 through the second transistor M2 during a period in which the first scan signal having the gate-on voltage may be supplied. For example, the second transistor M2 may be a switching transistor for transferring each data signal to the inside of the pixel PXL.

A first electrode of the capacitor Cst may be connected to the first node N1, and a second electrode of the capacitor Cst may be connected to the second node N2. The capacitor Cst may charge a voltage corresponding to the data signal supplied to the first node N1 during each frame period.

The third transistor M3 may be connected between the second node N2 and the sensing line SENL. A gate electrode of the third transistor M3 may be connected to the control line SSL (or the scan line SL). The third transistor M3 may be turned on in the case that the second scan signal (or the first scan signal) having the gate-on voltage (e.g., the logic high voltage or high level voltage) is supplied from the control line SSL, to transfer a reference voltage (or initialization voltage) supplied to the sensing line SENL to the second node N2 or to transfer a voltage of the second node N2 to the sensing line SENL. In an embodiment, the voltage of the second node N2 may be transferred to the sensing circuit through the sensing line SENL, and be provided to a driving circuit (e.g., a timing controller) to be used to compensate for a characteristic deviation of pixels PXL, and the like.

Although a case where the transistors M included in the pixel circuit PXC may be all N-type transistors is illustrated in FIGS. 19 and 20, embodiments are not limited thereto. For example, at least one of the first, second, and third transistors M1, M2, and M3 may be changed to a P-type transistor. The structure and driving method of the pixel PXL may be variously changed in some embodiments.

The light emitting unit EMU may include at least one light emitting element LD. In an embodiment, the light emitting unit EMU may include a single light emitting element LD connected in a forward direction between the first power source VDD and a second power source VSS. In another embodiment, the light emitting unit EMU may include light emitting elements LD connected in the forward direction between the first power source VDD and the second power source VSS. At least one light emitting element LD connected in the forward direction between the first power source VDD and the second power source VSS may constitute an effective light source of the pixel PXL.

In an embodiment, the light emitting unit EMU may include light emitting elements LD connected in parallel to each other between the pixel circuit PXC and the second power line PL2 as illustrated in an embodiment shown in FIG. 19. First end portions EP1 of the light emitting elements LD may be electrically connected to the pixel circuit PXC, and be electrically connected to the first power line PL1 through the pixel circuit PXC. Second end portions EP2 of the light emitting elements LD may be electrically connected to the second power line PL2. A voltage of the second power source VSS may be applied to the second power line PL2.

The number, kind, and/or structure of light emitting elements LD constituting effective light sources of the pixel PXL may be changed in some embodiments. The arrangement and/or connection structure of light emitting elements LD may be changed in some embodiments.

In an embodiment, the light emitting unit EMU may include light emitting elements LD connected in series-parallel between the pixel circuit PXC and the second power line PL2 as illustrated in an embodiment shown in FIG. 20. For example, the light emitting elements LD may be arranged and/or connected in at least two series stages between the pixel circuit PXC and the second power line PL2, and each series stage may include at least one light emitting element LD connected in the forward direction between the first power source VDD and the second power source VSS.

The first power source VDD and the second power source VSS may have different potentials. In an example, the first power source VDD may be a high-potential pixel power source, and the second power source VSS may be a low-potential pixel power source. A potential difference between the first power source VDD and the second power source VSS may be equal to or greater than a threshold voltage of the light emitting elements LD.

The light emitting elements LD may emit light with a luminance corresponding to the driving current supplied through the pixel circuit PXC. During each frame period, the pixel circuit PXC may supply a driving current corresponding to the data signal to the light emitting unit EMU. The driving current supplied to the light emitting unit EMU may allow the light emitting elements LD to emit light while flowing through the light emitting elements LD. Accordingly, the light emitting unit EMU can emit light with a luminance corresponding to the driving current.

Although only light emitting elements LD (i.e., effective light sources) connected in the forward direction between the first power source VDD and the second power source VSS are illustrated in FIGS. 19 and 20, embodiments are not limited thereto. For example, the light emitting unit EMU may further include at least one non-effective light source in addition to the light emitting elements LD constituting the respective effective light sources. In an example, the light emitting unit EMU may further include at least one non-effective light emitting element which is arranged in a reverse direction between the first power source VDD and the second power source or has at least one floated end portion.

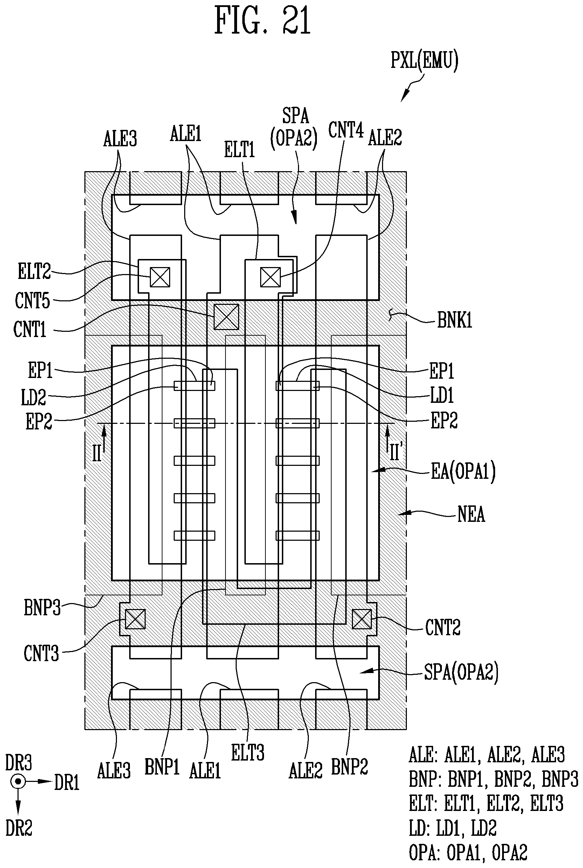

FIG. 21 is a plan view schematically illustrating a pixel in accordance with an embodiment of the disclosure. For example, FIG. 21 illustrates a structure of a pixel PXL, based on a light emitting unit EMU, and illustrates an embodiment of the light emitting unit EMU including light emitting elements LD connected in series-parallel to each other as illustrated in an embodiment shown in FIG. 20.

Referring to FIGS. 1 to 21, the pixel PXL may include a light emission area EA in which at least one light emitting element LD is disposed. In an embodiment, the light emission area EA may include at least two light emitting elements LD and electrodes electrically connected to the light emitting elements LD. In an embodiment, the electrodes may include alignment electrodes ALE and pixel electrodes ELT (also, referred to as "contact electrodes"). Also, the pixel PXL may further include bank patterns BNP disposed on the bottom of the alignment electrodes ALE.

The alignment electrodes ALE may have various shapes, and be spaced apart from each other. In an embodiment, the alignment electrodes ALE may be spaced apart from each other along the first direction DR1, and each of the alignment electrodes ALE may have a shape (e.g., a bar shape) extending along the second direction DR2.

The shape, size, number, positions, and/or arrangement structure of the alignment electrodes ALE may be variously changed in some embodiments. The alignment electrodes ALE may have shapes and/or sizes, which are similar or equal to one another, or have different shapes and different sizes.

The alignment electrodes ALE may include at least two electrodes spaced apart from each other. For example, the alignment electrodes ALE may include a first alignment electrode ALE1 and a second alignment electrode ALE2, and selectively further include a third alignment electrode ALE3.

In an embodiment, the first alignment electrode ALE1 may be located at the center of the light emission area EA, and the second alignment electrode ALE2 and the third alignment electrode ALE3 may be disposed at both sides of the first alignment electrode ALE1. For example, the second alignment electrode ALE2 may be disposed at a right side of the first alignment electrode ALE1, and the third alignment electrode ALE3 may be disposed at a left side of the first alignment electrode ALE1.

The alignment electrodes ALE (or alignment lines before being separated into alignment electrodes ALE of each pixel PXL) may be supplied with alignment signals necessary for alignment of light emitting elements LD in a process of aligning the light emitting elements LD. Accordingly, an electric field may be formed between the alignment electrodes ALE, so that the light emitting elements LD can be aligned and/or arranged between the alignment electrodes ALE. The light emitting elements LD may be aligned and/or arranged between the alignment electrodes ALE may mean that at least a portion of each of the light emitting elements LD may be disposed between the alignment electrodes ALE.

For example, the first alignment electrode ALE1, the second alignment electrode ALE2, and the third alignment electrode ALE3 (or a first alignment line in a state in which first alignment electrodes ALE1 of the pixels PXL may be connected to each other, a second alignment line in a state in which second alignment electrodes ALE2 of the pixels PXL may be connected to each other, and a third alignment line in a state in which third alignment electrodes ALE3 of the pixels PXL may be connected to each other) may be respectively supplied with a first alignment signal, a second alignment signal, and a third alignment signal in the process of aligning the light emitting elements LD. The first alignment signal and the second alignment signal may have different waveforms, different potentials, and/or different phases. Accordingly, an electric field may be formed between the first alignment electrode ALE1 and the second alignment electrode ALE2, so that light emitting elements LD (e.g., first light emitting elements LD1) can be aligned between the first alignment electrode ALE1 and the second alignment electrode ALE2. The first alignment signal and the third alignment signal may have different waveforms, different potentials, and/or different phases. Accordingly, an electric field may be formed between the first alignment electrode ALE1 and the third alignment electrode ALE3, so that light emitting elements LD (e.g., second light emitting elements LD2) can be aligned between the first alignment electrode ALE1 and the third alignment electrode ALE3. The third alignment signal may be a signal identical to or different from the second alignment signal.

The alignment electrodes ALE may be disposed in the light emission area EA of each pixel PXL. In an embodiment, the alignment electrodes ALE may extend to a separation area SPA while passing through a light non-emission area NEA at the periphery of the light emission area EA. The separation area SPA may be an area in which, after the light emitting elements LD are completely aligned, each alignment line (e.g., the first alignment line, the second alignment line, or a third alignment line) may be separated into alignment electrodes ALE of the pixels PXL (e.g., the first alignment electrodes ALE1, the second alignment electrodes ALE2, or the third alignment electrodes ALE3 of the pixels PXL), and be disposed at at least one side of each light emission area EA.

For example, each pixel PXL may include at least one separation area SPA disposed at the periphery of the light emission area EA (e.g., two separation areas SPA, disposed at an upper side and a lower side of each light emission area EA). An end portion of at least one electrode (e.g., end portions of the alignment electrodes ALE) constituting the light emitting unit EMU may be disposed in each separation area SPA.

In an embodiment, each alignment electrode ALE may have a pattern separated for each pixel PXL. For example, the first, second, and third alignment electrodes ALE1, ALE2, and ALE3 of each of the pixels PXL may respectively have patterns individually separated from one another.

However, the disclosure is not limited thereto. For example, in a structure in which second pixel electrodes ELT2 of the pixels PXL may be commonly connected to the second power line PL2, alignment electrodes (e.g., the third alignment electrodes ALE3 of the pixels PXL) connected to the second pixel electrodes ELT2 may not be cut off between adjacent pixels PXL along the first direction DR1 and/or the second direction DR2 but may be integrally formed.

In an embodiment, the first alignment electrode ALE1 may be electrically connected to a pixel circuit PXC (e.g., a pixel circuit PXC of a corresponding pixel PXL) and/or the first power line PL1 located in a circuit layer (e.g., a circuit layer PCL shown in FIG. 22) through a first contact part CNT1. The first alignment signal may be supplied to the first alignment electrode ALE1 (or the first alignment line) through at least one line (e.g., the first power line PL1) located in the circuit layer.

The first contact part CNT1 may include at least one contact hole and/or at least one via hole. In an embodiment, the first contact part CNT1 may be located in a light non-emission area NEA located at the periphery of each light emission area EA, but the position of the first contact part CNT1 may be changed. For example, the first contact part CNT1 may be disposed in each light emission area EA or each separation area SPA.

In an embodiment, the second alignment electrode ALE2 may be electrically connected to the second power line PL2 located in the circuit layer through a second contact part CNT2. The second alignment signal may be supplied to the second alignment electrode ALE2 (or the second alignment line) through the second power line PL2.

Similarly, the third alignment electrode ALE3 may be electrically connected to the second power line PL2 located in the circuit layer through a third contact part CNT3. The third alignment signal may be supplied to the third alignment electrode ALE3 (or the third alignment line) through the second power line PL2.

Each of the second contact part CNT2 and the third contact part CNT3 may include at least one contact hole and/or at least one via hole. In an embodiment, the second contact part CNT2 and the third contact part CNT3 may be located in a light non-emission area NEA located at the periphery of each light emission area EA, but the positions of the second contact part CNT2 and the third contact part CNT3 may be changed. For example, the second contact part CNT2 and the third contact part CNT3 may be disposed in each light emission area EA or each separation area SPA.

At least one first light emitting element LD1 may be disposed between the first alignment electrode ALE1 and the second alignment electrode ALE2. For example, multiple first light emitting elements LD1 may be arranged between the first alignment electrode ALE1 and the second alignment electrode ALE2.

Each first light emitting element LD1 may or may not overlap the first alignment electrode ALE1 and/or the second alignment electrode ALE2. A first end portion EP1 of the first light emitting element LD1 may be disposed adjacent to the first alignment electrode ALE1, and a second end portion EP2 of the first light emitting element LD1 may be disposed adjacent to the second alignment electrode ALE2.

The first end portion EP1 of the first light emitting element LD1 may be electrically connected to the pixel circuit PXC and/or the first power line PL1 through a first pixel electrode ELT1. For example, the first end portion EP1 of the first light emitting element LD1 may be electrically connected to the first alignment electrode ALE1 (or a bridge electrode corresponding to the first alignment electrode ALE1) through the first pixel electrode ELT1, and be electrically connected to the pixel circuit PXC and/or the first power line PL1 through the first alignment electrode ALE1.

The second end portion EP2 of the first light emitting element LD1 may be electrically connected to a third pixel electrode ELT3 and/or a second pixel electrode ELT2. In an embodiment, the second end portion EP2 of the first light emitting element LD1 may be electrically connected to the third pixel electrode ELT3. Also, the second end portion EP2 of the first light emitting element LD1 may be electrically connected to the second power line PL2 sequentially via the third pixel electrode ELT3, at least one second light emitting element LD2, the second pixel electrode ELT2, and the third alignment electrode ALE3.

At least one second light emitting element LD2 may be disposed between the first alignment electrode ALE1 and the third alignment electrode ALE3. For example, second light emitting elements LD2 may be arranged between the first alignment electrode ALE1 and the third alignment electrode ALE3.

Each second light emitting element LD2 may or may not overlap the first alignment electrode ALE1 and/or the third alignment electrode ALE3. A first end portion EP1 of the second light emitting element LD2 may be disposed adjacent to the first alignment electrode ALE1, and a second end portion EP2 of the second light emitting element LD2 may be disposed adjacent to the third alignment electrode ALE3.

The first end portion EP1 of the second light emitting element LD2 may be electrically connected to the third pixel electrode ELT3. The second end portion EP2 of the second light emitting element LD2 may be electrically connected to the second pixel electrode ELT2. In an embodiment, the second end portion EP2 of the second light emitting element LD2 may be electrically connected to the second power line PL2 through the second pixel electrode ELT2. For example, the second end portion EP2 of the second light emitting element LD2 may be electrically connected to the third alignment electrode ALE3 through the second pixel electrode ELT2, and be electrically connected to the second power line PL2 through the third alignment electrode ALE3. However, the disclosure is not limited thereto.

For example, each light emitting element LD (e.g., each first light emitting element LD1 or each second light emitting element LD2) may include a first end portion EP1 electrically connected to the first pixel electrode ELT1 and a second end portion EP2 electrically connected to the second pixel electrode ELT2. In an embodiment, each light emitting element LD may be an inorganic light emitting element having a subminiature size (e.g., having a size in a range of nanometers to micrometers), which uses a material having an inorganic crystalline structure). In an example, each light emitting element LD may be a subminiature inorganic light emitting element fabricated by growing a nitride-based semiconductor or a phosphide-based semiconductor. However, the kind, size, shape, structure, and/or number of light emitting elements LD constituting each light emitting unit EMU may be changed.

The light emitting elements LD may be dispersed in a solution to be prepared in the form of a light emitting element mixed liquor (or light emitting element ink), and be supplied to each light emission area EA through an inkjet process, a slit coating process, and/or the like. In the case that alignment signals are applied to the alignment electrodes ALE (or the alignment lines) of the pixels PXL at the same time when or after light emitting elements LD are supplied, an electric field is formed between the alignment electrodes ALE, so that the light emitting element LD can be aligned. After the light emitting elements LD may be completely aligned, a solvent of the light emitting element mixture liquor may be removed through a drying process or the like.

The first pixel electrode ELT1 (also, referred to as a "first electrode") may be disposed on first end portions EP1 of the first light emitting elements LD1, and be electrically connected to the first end portions EP1 of the first light emitting elements LD1. In an example, the first pixel electrode ELT1 may be directly disposed on the first end portions EP1 of the first light emitting elements LD1 to be in contact with the first end portions EP1 of the first light emitting elements LD1.

In an embodiment, the first pixel electrode ELT1 may overlap the first alignment electrode ALE1, and be electrically connected to the first alignment electrode ALE1 through a fourth contact part CNT4. Also, the first pixel electrode ELT1 may be electrically connected to the pixel circuit PXC and/or the first power line PL1 through the first alignment electrode ALE1. In another embodiment, the first pixel electrode ELT1 may not pass through the first alignment electrode ALE1, but may be directly electrically connected to the pixel circuit PXC and/or the first power line PL1.

The third pixel electrode ELT3 may be disposed on second end portions EP2 of the first light emitting elements LD1 and first end portions EP1 of the second light emitting elements LD2, and be electrically connected to the second end portions EP2 of the first light emitting elements LD1 and the first end portions EP1 of the second light emitting elements LD2. In an example, the third pixel electrode ELT3 may be directly disposed on the second end portions EP2 of the first light emitting elements LD1 and the first end portions EP1 of the second light emitting elements LD2 to be in contact with the second end portions EP2 of the first light emitting elements LD1 and the first end portions EP1 of the second light emitting elements LD2. The third pixel electrode ELT3 may be an intermediate electrode for electrically connecting the first light emitting elements LD1 and the second light emitting elements LD2 to each other. In an embodiment, the third pixel electrode ELT3 may overlap a portion of each of the first and second alignment electrodes ALE1 and ALE2, but the disclosure is not limited thereto.

The second pixel electrode ELT2 (also, referred to as a "second electrode") may be disposed on second end portions EP2 of the second light emitting elements LD2, and be electrically connected to the second end portions EP2 of the second light emitting elements LD2. In an example, the second pixel electrode ELT2 may be directly disposed on the second end portions EP2 of the second light emitting elements LD2 to be in contact with the second end portions EP2 of the second light emitting elements LD2.

In an embodiment, the second pixel electrode ELT2 may overlap the third alignment electrode ALE3, and be electrically connected to the third alignment electrode ALE3 through a fifth contact part CNT5. Also, the second pixel electrode ELT2 may be electrically connected to the second power line PL2 through the third alignment electrode ALE3. In another embodiment, the second pixel electrode ELT2 may not pass through the third alignment electrode ALE3, but may be directly electrically connected to the second power line PL2.

The pixel electrodes ELT (e.g., the first pixel electrode ELT1, the second pixel electrode ELT2, and the third pixel electrode ELT3) may be formed to be separated from each other in each light emission area EA. In an embodiment, at least one pixel electrode ELT may extend to a light non-emission area NEA and/or a separation area SPA from each light emission area EA. For example, the first pixel electrode ELT1 and the second pixel electrode ELT2 may extend to a light non-emission area NEA and/or a separation area SPA from each light emission area EA, and be electrically connected respectively to the first alignment electrode ALE1 and the third alignment electrode ALE3 in the separation area SPA. The third pixel electrode ELT3 may be formed in only each light emission area EA, or a portion of the third pixel electrode ELT3 may be located in a light non-emission area NEA. The positions, size, shape, and arrangement structure of the pixels electrode ELT and/or the positions of the fourth and fifth contact parts CNT4 and CNT5 may be variously changed in some embodiments.

The bank patterns BNP (also, referred to as "patterns" or "wall patterns") may be disposed on the bottom of the alignment electrode ALE to overlap a portion of the alignment electrodes ALE. For example, the bank patterns BNP may include a first bank pattern BNP1, a second bank pattern BNP2, and a third bank pattern BNP3, which respectively overlap a portion of the first alignment electrode ALE1, the second alignment electrode ALE2, and the third alignment electrode ALE3. In an embodiment, at least one bank pattern BNP may extend to the light non-emission area NEA at the periphery of the light emission area EA, but the disclosure is not limited thereto.

A portion of the alignment electrodes ALE may protrude in an upper direction of the pixel PXL (e.g., the third direction DR3). Accordingly, an area in which the light emitting elements LD are aligned can be readily controlled, and light emitted at a low angle toward the bank patterns BNP among lights emitted from the light emitting elements LD is reflected in the upper direction of the pixel PXL, thereby improving the light efficiency of the pixel PXL.

In an embodiment, at least two adjacent pixels PXL may share at least one bank pattern BNP. For example, the second bank pattern BNP2 may be integrally formed with a third bank pattern BNP3 of a pixel PXL adjacent in the first direction DR1 (e.g., a right adjacent pixel). Similarly, the third bank pattern BNP3 may be integrally formed with a second bank pattern BNP2 of another pixel adjacent in the first direction DR1 (e.g., a left adjacent pixel). The positions, structure, number, and/or shape of the bank patterns BNP may be variously changed in some embodiments.

A light non-emission area NEA may be disposed at the periphery of each light emission area EA and/or each separation area SPA. A first bank BNK1 may be disposed in the light non-emission area NEA.

The first bank BNK1 may include a first opening OPA1 corresponding to each light emission area EA, and surround the light emission area EA. Also, the first bank BNK1 may include second openings OPA2 corresponding to separation areas SPA, and surround the separation areas SPA. For example, the first bank BNK1 may include openings OPA corresponding to each light emission area EA and each separation area SPA.

The first bank BNK1 may include at least one light blocking material and/or at least one reflective material. For example, the first bank BNK1 may include at least one black matrix material and/or at least one color filter material of a specific color. Accordingly, light leakage between adjacent pixels PXL can be prevented.

The first bank BNK1 may define each light emission area EA to which light emitting elements LD may be supplied in a process of supplying the light emitting elements LD to each pixel PXL. For example, the light emission areas EA of the pixels PXL are separated and partitioned by the first bank BNK1, so that a desired kind and/or a desired amount of light emitting element mixed liquor can be supplied to each light emission area EA.

In an embodiment, the first bank BNK1 may include a hydrophobic surface. For example, the first bank BNK1 itself may be formed as a hydrophobic pattern by using a hydrophobic material, or a hydrophobic film made of a hydrophobic material may be formed on the first bank BNK1. Therefore, the first bank BNK1 may be formed to have a hydrophobic surface. In an example, the first bank BNK1 may be formed by using a hydrophobic organic insulating material having a large contact angle, such as polyacrylate. Therefore, the first bank BNK1 may be formed as a hydrophobic pattern. Accordingly, the light emitting element mixed liquor can stably flow into the light emission area EA.

FIG. 22 is a sectional view schematically illustrating a display device in accordance with an embodiment of the disclosure. For example, FIG. 22 illustrates an embodiment of a section of a display device DD, based on a section of a pixel PXL, which corresponds to line II-II' shown in FIG. 21.

Referring to FIGS. 1 to 22, the display device DD may include a base layer BSL, a circuit layer PCL, and a display layer DPL. The circuit layer PCL and the display layer DPL may be provided on the base layer BSL to overlap each other. In an example, the circuit layer PCL and the display layer DPL may be sequentially disposed on a surface of the base layer BSL.

The display device DD may further include a color filter layer CFL and/or an encapsulation layer ENC (or protective layer), disposed on the display layer DPL. In an embodiment, the color filter layer CFL and/or the encapsulation layer ENC may be formed directly on the surface of the base layer BSL on which the circuit layer PCL and the display layer DPL may be formed, but the disclosure is not limited thereto.

The base layer BSL may be a substrate or a film, which is made of a rigid or flexible material. In an embodiment, the base layer BSL may include at least one transparent or opaque insulating material, and have a single-layer structure or a multi-layer structure.

The circuit layer PCL may be provided on the surface of the base layer BSL. The circuit layer PCL may include circuit elements constituting a pixel circuit PXC of each pixel PXL. For example, circuit elements (e.g., transistors M and a capacitor Cst, which constitute each pixel circuit PXC) may be formed in each pixel area of the circuit layer PCL.

In FIG. 22, any one transistor M (e.g., a first transistor M1 including a bottom metal layer BML) provided in each pixel circuit PXC will be illustrated as an example of circuit elements which may be disposed in the circuit layer PCL.

Also, the circuit layer PCL may include various signal lines and power lines, which may connected to the pixels PXL. For example, the circuit layer PCL may include scan lines SL, control lines SSL, data lines DL, sensing lines SENL, and/or first and second power lines PL1 and PL2, which may be connected to the pixels PXL. In FIG. 22, lines LI located in the same layer (e.g., a first conductive layer) as the bottom metal layer BML are illustrated as an example of lines which may be disposed in the circuit layer PCL. Each line LI may be any one of the signal lines and the power lines, which may be connected to the pixels PXL. In an embodiment, at least one signal line and/or at least one power line may be disposed even in another layer of the circuit layer PCL.

The circuit layer PCL may include insulating layers. For example, the circuit layer PCL may include a buffer layer BFL, a gate insulating layer GI, an interlayer insulating layer ILD, and/or a passivation layer PSV, which may be sequentially disposed on the surface of the base layer BSL.

The circuit layer PCL may include a first conductive layer which is disposed on the base layer BSL and includes a bottom metal layer BML of a first transistor M1. In an example, the first conductive layer may be disposed between the base layer BSL and the buffer layer BFL, and include a bottom metal layer BML of a first transistor M1 provided in each pixel circuit PXC. The bottom metal layer BML of the first transistor M1 may overlap a gate electrode GE and a semiconductor pattern SCP of the first transistor M1.

Also, the first conductive layer may further include at least one line LI. For example, the first conductive layer may include at least some lines LI among lines extending in the second direction DR2 in the display area DA. In an example, the first conductive layer may include sensing lines SENL, data lines DL, a first power line PL1 (or a first sub-power line in the second direction, which constitutes the mesh-type first power line PL1), and/or a second power line PL2 (or a second sub-power line in the second direction, which constitute the mesh-type second power line PL2), which may be connected to the pixels PXL.

The buffer layer BFL may be disposed on the surface of the base layer BSL including the first conductive layer. The buffer layer BFL may prevent an impurity from being diffused into each circuit element.

A semiconductor layer may be disposed on the buffer layer BFL. The semiconductor layer may include a semiconductor pattern SCP of each transistor M. The semiconductor pattern SCP may include a channel region overlapping a gate electrode GE of a corresponding transistor M, and first and second conductive regions (e.g., source and drain regions) disposed at both sides of the channel region. The semiconductor pattern SCP may be a semiconductor pattern made of poly-silicon, amorphous silicon, an oxide semiconductor, and/or the like.

The gate insulating layer GI may be disposed on the semiconductor layer. A second conductive layer may be disposed on the gate insulating layer GI.

The second conductive layer may include a gate electrode GE of each transistor M. Also, the second conductive layer may further include one electrode of a capacitor Cst provided in the pixel circuit PXC and/or a bridge pattern. In the case that at least one power line and/or at least one signal line, disposed in the display area DA, are/is configured as a multi-layer, the second conductive layer may further include at least one conductive pattern constituting the at least one power line and/or the at least one signal line.

The interlayer insulating layer ILD may be disposed over the second conductive layer. A third conductive layer may be disposed on the interlayer insulating layer ILD.

The third conductive layer may include a source electrode SE and a drain electrode DE of each transistor M. The source electrode SE may be connected to a region (e.g., the source region) of a semiconductor pattern SCP included in a corresponding transistor M through at least one contact hole CH, and the drain electrode DE may be connected to another area (e.g., the drain region) of the semiconductor pattern SCP included in the corresponding transistor M through at least another contact hole CH. Also, the third conductive layer may further include another electrode of the capacitor Cst provided in the pixel circuit PXC, lines, and/or a bridge pattern. For example, the third conductive layer may include at least some lines among lines extending in the first direction DR1 in the display area DA. In an example, the third conductive layer may include scan lines SL, control lines SSL, a first power line PL1 (or a first sub-power line in the first direction, which constitutes the mesh-type first power line PL1), and/or a second power line PL2 (or a second sub-power line in the first direction, which constitute the mesh-type second power line PL2), which are connected to the pixels PXL. In the case that at least one power line and/or at least one signal line, disposed in the display area DA, are/is configured as a multi-layer, the third conductive layer may further include at least one conductive pattern constituting the at least one power line and/or the at least one signal line.

Each conductive pattern, each electrode, and/or each line, which constitute the first to third conductive layers, may include at least one conductive material, thereby having conductivity, and the material constituting each conductive pattern, each electrode, and/or each line is not particularly limited. In an example, each conductive pattern, each electrode, and/or each line, which constitute the first to third conductive layers, may include at least one metal selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu). Each conductive pattern, each electrode, and/or each line, which constitute the first to third conductive layers, may include various kinds of conductive materials.

The passivation layer PSV may be disposed over the third conductive layer. Each of the buffer layer BFL, the gate insulating layer GI, the interlayer insulating layer ILD, and the passivation layer PSV may be configured as a single layer or a multi-layer, and include at least one inorganic insulating material and/or at least one organic insulating material. In an embodiment, each of the buffer layer BFL, the gate insulating layer GI, the interlayer insulating layer ILD, and the passivation layer PSV may include various kinds of inorganic insulating materials including silicon nitride (SiNₓ), silicon oxide (SiOₓ), silicon oxynitride (SiOₓN_{y}), and/or the like. In an embodiment, the passivation layer PSV may include at least one organic insulating layer including at least one organic insulating material. In an embodiment, the passivation layer PSV may be entirely disposed in at least the display area DA, and planarize a surface of the circuit layer PCL.

The display layer DPL may be disposed on the passivation layer PSV.

The display layer DPL may include a light emitting unit EMU of each pixel PXL. For example, the display layer DPL may include alignment electrodes ALE, at least one light emitting element LD, and pixel electrodes ELT, which are disposed in a light emission area EA of each pixel PXL. In an embodiment, each light emitting unit EMU may include multiple light emitting elements LD.

The display layer DPL may further include insulating patterns and/or insulating layers, which may be sequentially disposed on the surface of the base layer BSL on which the circuit layer PCL is formed. For example, the display layer DPL may include bank patterns BNP, a first insulating layer INS1, a first bank BNK1, a second insulating layer INS2, a third insulating layer INS3, a second bank BNK2, and/or a fourth insulating layer INS4. Also, the display layer DPL may selectively further include a light conversion layer CCL.

The bank patterns BNP may be disposed on the passivation layer PSV. The bank patterns BNP may be disposed on the bottom of the alignment electrodes ALE to overlap a portion of each of the alignment electrodes ALE.

The alignment electrodes ALE may protrude in an upper direction of the pixel PXL (e.g., the third direction DR3) at the periphery of the light emitting elements LD. The bank patterns BNP and the alignment electrodes ALE on the top thereof may form a reflective protrusion pattern at the periphery of the light emitting elements LD. Accordingly, the light efficiency of the pixel PXL can be improved.

The bank patterns BNP may be single-layer or multi-layer insulating patterns including an inorganic insulating material and/or an organic insulating material. The alignment electrodes ALE may be disposed on the bank patterns BNP.

The alignment electrodes ALE may include at least one conductive material. In an example, each alignment electrode ALE may include at least one metal or any alloy including the same among various metallic materials including silver (Ag), magnesium (Mg), aluminium (Al), platinum (Pt), palladium (Pd), gold (Au), nickel (Ni), neodymium (Nd), iridium (Ir), chromium (Cr), titanium (Ti), molybdenum (Mo), copper (Cu), and the like, a conductive oxide such as Indium Tin Oxide (ITO), Indium Zinc Oxide (IZO), Indium Tin Zinc Oxide (ITZO), Zinc Oxide (ZnO), Aluminium doped Zinc Oxide (AZO), Gallium doped Zinc Oxide (GZO), Zinc Tin Oxide (ZTO), Gallium Tin Oxide (GTO), and Fluorine doped Tin Oxide (FTO), and at least one conductive material among conductive polymers such as PEDOT, but the disclosure is not limited thereto. For example, the alignment electrodes ALE may include another conductive material including carbon nano tubes, graphene, and/or the like. For example, the alignment electrodes ALE may include at least one of various conductive materials, to have conductivity. Also, the alignment electrodes ALE may include the same conductive material or different conductive materials.

Each alignment electrode ALE may be configured as a single layer or a multi-layer. In an example, each alignment electrode ALE may include a reflective electrode layer including a reflective conductive material (e.g., a metal), and be configured as a single-layer or multi-layer electrode.

The first insulating layer INS1 may be disposed over the alignment electrodes ALE. In an embodiment, the first insulating layer INS1 may include a contact hole for connecting at least one of the alignment electrodes ALE to any one pixel electrode ELT. For example, the first insulating layer INS1 may include contact holes for constituting the fourth and fifth contact parts CNT4 and CNT5 shown in FIG. 21.

The first insulating layer INS1 may be configured as a single layer or a multi-layer, and include an inorganic insulating material and/or an organic insulating material. In an embodiment, the first insulating layer INS1 may include at least one kind of inorganic insulating material including silicon nitride (SiNₓ), silicon oxide (SiOₓ), and silicon oxynitride (SiOₓN_{y}).

As the alignment electrodes ALE may be covered by the first insulating layer INS1, the alignment electrodes ALE can be prevented from being damaged in a subsequent process. A short-circuit defect can be prevented from occurring as alignment electrodes ALE and light emitting elements LD may be inappropriately connected to each other.

The first bank BNK1 may be disposed in the display area DA in which the alignment electrodes ALE and the first insulating layer INS1 are formed. The first bank BNK1 may be formed in a light non-emission area NEA to surround a light emission area EA of each pixel PXL.

Light emitting elements LD may be supplied to each light emission area EA surrounded by the first bank BNK1. The light emitting elements LD may be aligned between alignment electrodes ALE by alignment signals applied to alignment electrodes ALE (or alignment lines before being separated into alignment electrodes ALE of each pixel PXL). For example, in the case that the pixel PXL includes a first alignment electrode ALE1 located at the center and second and third alignment electrodes ALE2 and ALE3 located at both sides of the first alignment electrode ALE1, at least one first light emitting element LD1 may be aligned between the first alignment electrode ALE1 and the second alignment electrode ALE2, and at least one second light emitting element LD2 may be aligned between the first alignment electrode ALE1 and the third alignment electrode ALE3.

The second insulating layer INS2 may be disposed on a portion of each of the light emitting elements LD. In an embodiment, the second insulating layer INS2 may be locally disposed on a portion including a central portion of each of the light emitting elements LD to expose first and second end portions EP1 and EP2 of each of the light emitting elements LD aligned in a light emission area EA of a corresponding pixel PXL. In another embodiment, the second insulating layer INS2 may be entirely formed in the display area DA including multiple pixel areas, and include contact holes exposing the first and second end portions EP1 and EP2 of each of the light emitting elements LD. In case that the second insulating layer INS2 is formed on the top of the light emitting elements LD, the light emitting elements LD can be stably fixed.

The second insulating layer INS2 may be configured as a single layer or a multi-layer, and include at least one inorganic insulating material and/or at least one organic insulating material. For example, the second insulating layers INS2 may include various kinds of organic insulating material and/or inorganic insulating materials including silicon nitride (SiNₓ), silicon oxide (SiOₓ), silicon oxynitride (SiOₓN_{y}), aluminium oxide (AlₓO_{y}), a photoresist material, and/or the like.

Different pixel electrodes ELT may be disposed and/or formed on both end portions, e.g., first and second end portions EP1 and EP2 of light emitting elements LD which may not be covered by the second insulating layer INS2. For example, a first pixel electrode ELT1 may be disposed on a first end portion EP1 of the first light emitting element LD1, and a portion of a third pixel electrode ELT3 may be disposed on a second end portion EP2 of the first light emitting element LD1. Another portion of the third pixel electrode ELT3 may be disposed on a first end portion EP1 of the second light emitting element LD2, and a second pixel electrode ELT2 may be disposed on a second end portion EP2 of the second light emitting element LD2.

In an embodiment, the first pixel electrode ELT1 may be electrically connected to the first alignment electrode ALE1 through at least one contact part (e.g., the fourth contact part CNT4 shown in FIG. 21). Similarly, the second pixel electrode ELT2 may be electrically connected to the third alignment electrode ALE3 through at least one contact part (e.g., the fifth contact part CNT5 shown in FIG. 21). The third pixel electrode ELT3 may electrically connect at least one first light emitting element LD1 and at least one second light emitting element LD2 to each other.

In an embodiment, a first alignment electrode ALE1 of each pixel PXL may be electrically connected to a first transistor M1 of the corresponding pixel PXL through at least one contact part (e.g., the first contact part CNT1 shown in FIG. 21). Similarly, second and third alignment electrodes ALE2 and ALE3 may be electrically connected to the second power line PL2 respectively through at least one contact part (e.g., the second contact part CNT2 and the third contact part CNT3).

The first pixel electrode ELT1 may be disposed on the top of the first alignment electrode ALE1 to overlap a portion of the first alignment electrode ALE1, and the second pixel electrode ELT2 may be disposed on the top of the third alignment electrode ALE3 to overlap a portion of the third alignment electrode ALE3. The third pixel electrode ELT3 may be disposed on the top of the first alignment electrode ALE1 and the second alignment electrode ALE2 to overlap another portion of the first alignment electrode ALE1 and the second alignment electrode ALE2.

In an embodiment, the first pixel electrode ELT1 may be electrically connected to the first end portion EP1 of the first light emitting element LD1, and the second pixel electrode ELT2 may be electrically connected to the second end portion EP2 of the second light emitting element LD2. The third pixel electrode ELT3 may be electrically connected to the second end portion EP2 of the first light emitting element LD1 and the first end portion EP1 of the second light emitting element LD2.

The first pixel electrode ELT1, the second pixel electrode ELT2, and/or the third pixel electrode ELT3 may be formed in the same layer or be formed in different layers. In an embodiment, the first and second pixel electrodes ELT1 and ELT2 may be formed in the same layer, and the third pixel electrode ELT3 may be formed in a layer different from the layer in which the first and second pixel electrodes ELT1 and ELT2 are formed. For example, the first and second pixel electrodes ELT1 and ELT2 and the third pixel electrode ELT3 may be disposed in different layers with the third insulating layer INS3 interposed therebetween. In another embodiment, the first to third pixel electrodes ELT1 to ELT3 may all be formed in the same layer. The pixel PXL may not include the third insulating layer INS3. The mutual positions and/or formation order of the pixel electrodes ELT may be variously changed in some embodiments.

In the case that each pixel PXL includes a light emitting unit EMU having a parallel structure as illustrated in an embodiment shown in FIG. 19, and the like or in the case that each pixel PXL includes a single light emitting element LD, the pixel PXL may not include the third pixel electrode ELT3. The first pixel electrode ELT1 may be disposed on first end portions EP1 of the light emitting elements LD, and the second pixel electrode ELT2 may be disposed on second end portions EP2 of the light emitting elements LD.

The pixel electrodes ELT may include at least one conductive material. In an embodiment, the pixel electrodes ELT may include a transparent conductive material to allow light generated from the light emitting elements LD to be transmitted therethrough.

In an embodiment, the display device may include a light conversion layer CCL disposed on a light emitting unit EMU of each pixel PXL. For example, the light conversion layer CCL may be provided in each light emission area EA to be located on the top of light emitting elements LD of each pixel PXL.

Also, the display device DD may further include a second bank BNK2 disposed in the light non-emission area NEA to overlap the first bank BNK1. The second bank BNK2 may define (or partition) each light emission area EA in which the light conversion layer CCL may be formed. In an embodiment, the second bank BNK2 may be integrated with the first bank BNK1.

The second bank BNK2 may include a light blocking material and/or a reflective material, including a black matrix material and the like. The second bank BNK2 may include the same material as the first bank BNK1 or include a material different from the material of the first bank BNK1.

The light conversion layer CCL may include at least one of wavelength conversion particles (or color conversion particles) for converting a wavelength and/or a color of light emitted from the light emitting elements LD and light scattering particles SCT for improving light emission efficiency by scattering light emitted from the light emitting elements LD. In an example, each light conversion layer CCL may be disposed on each light emitting unit EMU. Each light conversion layer CCL includes wavelength conversion particles such as at least one kind of quantum dot QD (e.g., a red quantum dot, a green quantum dot, and/or a blue quantum dot) and/or light scattering particles SCT.

For example, in the case that any one pixel PXL is set as a red (or green) sub-pixel, and blue light emitting elements LD are provided to a light emitting unit EMU of the pixel PXL, a light conversion layer CCL including a red (or green) quantum dot QD for converting blue light into red (or green) light may be disposed on the light emitting unit EMU of the pixel PXL. The light conversion layer CCL may further include light scattering particles SCT.

The fourth insulating layer INS4 may be formed on the surface of the base layer BSL including light emitting units EMU and/or light conversion layers CCL of the sub-pixels SPX.

In an embodiment, the fourth insulating layer INS4 may include at least one organic insulating layer. The fourth insulating layer INS4 may be entirely disposed in at least the display area DA, and substantially planarize a surface of the display layer DPL. Also, the fourth insulating layer INS4 may protect the light emitting units EMU and/or the light conversion layers CCL of the pixels PXL.

The color filter layer CFL may be disposed on the fourth insulating layer INS4.

The color filter layer CFL may include color filters CF corresponding to colors of the pixels PXL. For example, the color filter layer CFL may include a first color filter CF1 disposed in a light emission area EA of a first color pixel PXL1, a second color filter CF2 disposed in a light emission area EA of a second color pixel PXL2, and a third color filter CF3 disposed in a light emission area EA of a third color pixel PXL3. Each color filter CF may be provided on the fourth insulating layer INS4 to overlap a light emitting unit EMU of a corresponding pixel PXL.

In an embodiment, the first, second, and third color filters CF1, CF2, and CF3 may be disposed to overlap one another in the light non-emission area NEA. In another embodiment, the first, second, and third color filters CF1, CF2, and CF3 may be formed in a light emission area EA of each pixel PXL to be separated from each other, and a separate light blocking pattern or the like may be disposed between the first, second, and third color filters CF1, CF2, and CF3.

The encapsulation layer ENC may be disposed on the color filter layer CFL. The encapsulation layer ENC may include a fifth insulating layer INS5. In an embodiment, the fifth insulating layer INS5 may include at least one organic insulating layer including at least one organic insulating material, and be configured as a single layer or a multi-layer. The fifth insulating layer INS5 may be entirely formed in at least the display area DA to cover the circuit layer PCL, the display layer DPL, and/or the color filter layer CFL, and planarize a surface of the display device DD.

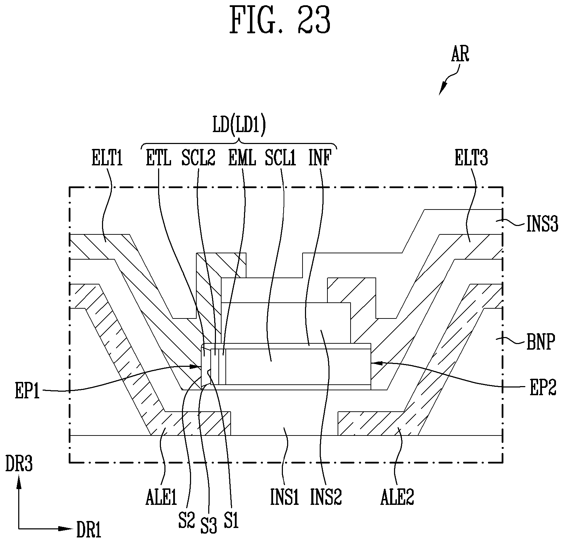

FIG. 23 is an enlarged schematic sectional view of an area of the pixel shown in FIG. 22. For example, FIG. 23 is an enlarged sectional view of one area (e.g., area AR shown in FIG. 22) of the pixel PXL, based on the first light emitting element LD1. In an embodiment, the light emitting elements LD included in the pixels PXL may be light emitting elements LD having kinds and/or structures, which may be substantially identical or similar to each other. For example, the second light emitting element LD2 may be a light emitting element LD having the same kind and/or the same structure as the first light emitting element LD1.

Although an embodiment in which the pixel PXL shown in FIG. 22 includes the light emitting element LD in accordance with an embodiment shown in FIGS. 1 and 2 is illustrated in FIG. 23, the disclosure is not limited thereto. For example, the pixel PXL may include the light emitting element LD in accordance with any embodiment among the embodiments shown in FIGS. 3 to 5, or a light emitting element(s) LD having a shape and/or a structure, to which a combination of at least two embodiments among the embodiments shown in FIGS. 3 to 5 is applied. In an embodiment shown in FIG. 23, detailed descriptions of components similar or identical to those of the above-described embodiments will be omitted.

Referring to FIGS. 1 to 23, each light emitting element LD included in the pixel PXL may include a first semiconductor layer SCL1, a light emitting layer EML, a second semiconductor layer SCL2, and an electrode layer ETL, which may be sequentially disposed in a direction from a second end portion EP2 to a first end portion EP1. Also, each light emitting element LD may include an insulative film INF surrounding side surfaces of the first semiconductor layer SCL1, the light emitting layer EML, the second semiconductor layer SCL2, and the electrode layer ETL.

The electrode layer ETL may include a first surface S1 adjacent to the second semiconductor layer SCL2 (e.g., in contact with the second semiconductor layer SCL2), a second surface S2 which faces the first surface S1 and has a width and/or an area, greater than a width and/or an area of the first surface S1, and a side surface S3 connecting the first surface S1 and the second surface S2 to each other. The side surface S3 of the electrode layer ETL may have a slope corresponding to an angle θ (see FIG. 2) in a range of about 90 degrees to about 135 degrees with respect to the first surface S1 of the electrode layer ETL.

The insulative film INF may completely surround side surfaces of the light emitting layer EML and the second semiconductor layer SCL2, and at least partially surround side surfaces of the electrode layer ETL and the first semiconductor layer SCL1. The insulative film INF may expose a portion of the electrode layer ETL and the first semiconductor layer SCL1 respectively at the first end portion EP1 and the second end portion EP2 of the light emitting element LD.

The electrode layer ETL may be electrically connected to the first pixel electrode ELT1. In an example, the electrode layer ETL may be in direct contact with the first pixel electrode ELT1 at the first end portion EP1 of the light emitting element LD, at which the second insulating layer INS2 may not be provided, to be electrically connected to the first pixel electrode ELT1.

In an embodiment, the electrode layer ETL may be in direct contact with the second semiconductor layer SCL2 at the first surface S1. The side surface S3 of the electrode layer ETL may be surrounded by the insulative film INF at a portion corresponding to at least the first surface S1. For example, the insulative film INF may surround at least a portion of the side surface S3 of the electrode layer ETL, which may be located at the periphery of the first surface S1 of the electrode layer ETL. The insulative film INF may expose the second surface S2 of the electrode layer ETL and another portion of the side surface S3 of the electrode layer ETL, which may be located at the periphery of the second surface S2.

The first semiconductor layer SCL1 may be electrically connected to the third pixel electrode ELT3 (and/or the second pixel electrode ELT2). In an example, the first semiconductor layer SCL1 may be in direct contact with the third pixel electrode ELT3 at the second end portion EP2 of the light emitting element LD, at which the second insulating layer INS2 may not be provided, to be electrically connected to the third pixel electrode ELT3.

Although the technical idea of the present invention has been described in detail according to the above-described embodiments, it should be noted that the above embodiments are for explanation and not limitation. Additionally, those skilled in the art will understand that various modifications are possible within the scope of the technical idea of the present invention.

The scope of the present invention is not limited to what is described in the detailed description of the specification, but should be defined by the claims. In addition, the meaning and scope of the patent claims and all changes or modified forms derived from the equivalent concept thereof should be construed as being included in the scope of the present invention.

## Claims

1. A light emitting element comprising:
a first semiconductor layer;
a light emitting layer disposed on the first semiconductor layer;
a second semiconductor layer disposed on the light emitting layer;
an electrode layer disposed on the second semiconductor layer; and
an insulative film surrounding side surfaces of the first semiconductor layer, the light emitting layer, and the second semiconductor layer, the insulative film surrounding a portion of the electrode layer at a first end portion at which the electrode layer is disposed,
wherein the electrode layer includes:
a first surface adjacent to the second semiconductor layer; and
a second surface facing the first surface, the second surface having a width greater than a width of the first surface.

2. The light emitting element of claim 1, wherein the width of the second surface of the electrode layer is greater than or equal to a width of an upper surface of the second semiconductor layer, which contacts the first surface of the electrode layer.

3. The light emitting element of claim 2, wherein the width of the first surface of the electrode layer is smaller than or equal to the width of the upper surface of the second semiconductor layer.

4. The light emitting element of claim 1, wherein
the electrode layer further includes a side surface extending from the first surface to the second surface, and
the side surface of the electrode layer has a slope corresponding to an angle in a range of about 90 degrees to about 135 degrees with respect to the first surface.

5. The light emitting element of claim 1, wherein the insulative film has a thickness changed at the first end portion.

6. The light emitting element of claim 5, wherein the insulative film has a thickness increasing as it becomes closer to the first surface of the electrode layer from the second surface of the electrode layer.

7. The light emitting element of claim 1, wherein a concave groove is formed in the electrode layer at a boundary at which the electrode layer contacts the second semiconductor layer.

8. The light emitting element of claim 1, wherein the insulative film completely surrounds side surfaces of the light emitting layer and the second semiconductor layer.

9. The light emitting element of claim 1, wherein the first surface of the electrode layer directly contacts the second semiconductor layer.

10. The light emitting element of claim 9, wherein
the insulative film surrounds at least a portion of the side surface of the electrode layer, which is located at a periphery of the first surface of the electrode layer, and
the insulative film exposes the second surface of the electrode layer.

11. The light emitting element of claim 1, wherein the insulative film exposes a lower surface of the first semiconductor layer.

12. The light emitting element of claim 1, wherein
the first semiconductor layer includes a first part adjacent to the light emitting layer and a second part except the first part, and
a width of the first part is greater than a width of the second part.

13. The light emitting element of claim 12, wherein the insulative film has a thickness at a portion surrounding the second part of the first semiconductor layer, which is greater than a thickness at a portion surrounding the first part of the first semiconductor layer.

14. A display device comprising:
a pixel including:
a first electrode;
a second electrode; and
a light emitting element including a first end portion electrically connected to the first electrode and a second end portion electrically connected to the second electrode, wherein
the light emitting element includes:
a first semiconductor layer, a light emitting layer, a second semiconductor layer, and an electrode layer, which are sequentially disposed in a direction from the second end portion to the first end portion; and
an insulative film surrounding side surfaces of the first semiconductor layer, the light emitting layer, the second semiconductor layer, and the electrode layer, and
the electrode layer includes:
a first surface adjacent to the second semiconductor layer; and
a second surface facing the first surface, the second surface having a width greater than a width of the first surface.

15. The display device of claim 14, wherein the insulative film completely surrounds side surfaces of the light emitting layer and the second semiconductor layer.

16. The display device of claim 14, wherein
the first surface of the electrode layer directly contacts the second semiconductor layer, and
the insulative film surrounds at least a portion of the side surface of the electrode layer, which is located at the periphery of the first surface of the electrode layer, and
the insulative film exposes the second surface of the electrode layer.

17. A method of fabricating a light emitting element, the method comprising:
sequentially forming a first semiconductor layer, a light emitting layer, and a second semiconductor layer on a substrate;
sequentially forming a mask layer and an etch pattern on the second semiconductor layer;
patterning, in a rod shape, a stack structure including the first semiconductor layer, the light emitting layer, and the second semiconductor layer through an etching process using the mask layer and the etch pattern;
forming an electrode layer on the second semiconductor layer;
forming an insulative film on side surfaces of the first semiconductor layer, the light emitting layer, the second semiconductor layer, and the electrode layer; and
separating, from the substrate, a light emitting element including the stack structure and the insulative film provided on a side surface of the stack structure,
wherein, in the forming of the electrode layer, the electrode layer is etched such that the side surface of the electrode layer has a slope corresponding to an angle in a range of about 90 degrees to about 135 degrees with the substrate.

18. The method of claim 17, wherein the forming of the electrode layer includes:
entirely forming the electrode layer on a surface of the substrate on which the stack structure is formed;
performing heat treatment on the electrode layer; and
etching the heat-treated electrode layer.

19. The method of claim 18, wherein a first surface of the electrode layer, which is adjacent to the second semiconductor layer, and a second surface of the electrode layer, which faces the first surface, are etched at different speeds by the heat treatment.

20. The method of claim 19, wherein a width of the second surface of the electrode layer is greater than or equal to a width of an upper surface of the second semiconductor layer, which contacts the first surface.
